# EUROPEAN PATENT APPLICATION

(11) **EP 4 783 165 A2**
(43) Date of publication of application: **29.07.2026**
(21) Application number: 26150437.7
(22) Date of filing: 06.01.2026
(51) Int. Cl.: G11C 5/02, G11C 16/04, G11C 16/08, G11C 16/24, G11C 16/26, G11C 16/30, H10B 41/27, H10B 43/27

(54) **3D NONVOLATILE MEMORY DEVICE**

(30) Priority: 24.01.2025 KR 20250011893
(71) Applicant: Samsung Electronics Co., Ltd., Suwon-si, Gyeonggi-do 16677 (KR)
(72) Inventor: LEE, Myunghun, 16677 Suwon-si (KR); KWON, Hyuckjoon, 16677 Suwon-si (KR); KIM, Junhyoung, 16677 Suwon-si (KR); SHIN, Homoon, 16677 Suwon-si (KR)
(74) Representative: Marks & Clerk LLP

(57) **Abstract**

A nonvolatile memory device includes a memory cell region and a peripheral circuit region. The memory cell region includes a plurality of memory cell arrays disposed in a first direction. Each of the plurality of memory cell arrays includes a plurality of sub-planes disposed in the first direction and extending in a second direction intersecting the first direction. The peripheral circuit region is disposed below the memory cell region in a vertical direction and includes a plurality of page buffer circuits respectively coupled with the plurality of memory cell arrays. Each of the plurality of memory cell arrays further includes a first common source plate extending in the first direction and commonly coupled with the plurality of sub-planes, and first and second bit line groups respectively coupled with first and second sub-planes of the plurality of sub-planes.

## Description

### BACKGROUND

The present disclosure relates generally to memory devices, and more particularly, to a three-dimensional (3D) nonvolatile memory device in which a memory cell array is arranged in a vertical direction with respect to a peripheral circuit.

Three-dimensional (3D) nonvolatile memory devices, in which memory cell arrays and/or peripheral circuits are arranged vertically, may have been developed in response to demand for higher capacity and/or miniaturization of nonvolatile memory devices. For example, advances in semiconductor process technology may have created demand for reductions in chip sizes, which may be addressed by implementation of 3D nonvolatile memory devices. In addition, 3D nonvolatile memory devices may also address a growing demand to increase the number of memory dies formed per wafer and/or to improve wafer utilization efficiency.

### SUMMARY

One or more example embodiments of the present disclosure provide a nonvolatile memory device capable of reducing a chip size, improving utilization efficiency of a wafer, and/or improving performance of a memory device, when compared to related memory devices.

According to an aspect of the present disclosure, a nonvolatile memory device includes a memory cell region and a peripheral circuit region. The memory cell region includes a plurality of memory cell arrays arranged in a first direction. Each of the plurality of memory cell arrays includes a plurality of sub-planes disposed in the first direction. Each of the plurality of sub-planes extend in a second direction intersecting the first direction. The peripheral circuit region is disposed below the memory cell region in a vertical direction. The peripheral circuit region includes a plurality of page buffer circuits respectively coupled with the plurality of memory cell arrays. Each of the plurality of memory cell arrays further includes a first common source plate extending in the first direction and commonly coupled with the plurality of sub-planes, a first bit line group coupled with a first sub-plane from among the plurality of sub-planes, and a second bit line group coupled with a second sub-plane from among the plurality of sub-planes. Each of the plurality of page buffer circuits includes first page buffers coupled with the first sub-plane through the first bit line group, and second page buffers coupled with the second sub-plane through the second bit line group.

According to an aspect of the present disclosure, a nonvolatile memory device includes a memory cell region and a peripheral circuit region. The memory cell region includes a plurality of memory cell arrays and upper bonding pads. The plurality of memory cell arrays include a first memory cell array, a second memory cell array, a third memory cell array, and a fourth memory cell array. The first memory cell array and the second memory cell array are arranged in a first direction. The third memory cell array and the fourth memory cell array are arranged in the first direction. The first memory cell array and the third memory cell array are disposed apart from each other in a second direction intersecting the first direction. The second memory cell array and the fourth memory cell array are disposed apart from each other in the second direction. The peripheral circuit region includes a plurality of page buffer circuits and lower bonding pads. The plurality of page buffer circuits include a first page buffer circuit, a second page buffer circuit, a third page buffer circuit, and a fourth page buffer circuit. The plurality of page buffer circuits are respectively coupled with the plurality of memory cell arrays. The peripheral circuit region is coupled with the memory cell region by the upper bonding pads and the lower bonding pads in a vertical direction. Each of the plurality of memory cell arrays includes a plurality of sub-planes arranged in the first direction. Each of the plurality of sub-planes extend in the second direction. The plurality of sub-planes are respectively coupled with a plurality of different bit line groups. Each of the plurality of page buffer circuits includes a plurality of page buffers respectively coupled with the plurality of sub-planes. The plurality of page buffers may be coupled to the plurality of sub-planes via the plurality of different bit line groups.

According to an aspect of the present disclosure, a nonvolatile memory device includes a memory cell region and a peripheral circuit region. The memory cell region includes a plurality of memory cell arrays arranged in an array form on a first wafer and upper bonding pads coupled with the plurality of memory cell arrays. The peripheral circuit region includes lower bonding pads disposed on a second wafer. The peripheral circuit region is coupled with the memory cell region by the upper bonding pads and the lower bonding pads in a vertical direction. Each of the plurality of memory cell arrays includes a plurality of sub-planes arranged in a first direction, a plurality of bit line groups respectively coupled with the plurality of sub-planes, a first common source plate extending in the first direction, and a second common source plate extending in the first direction. Each of plurality of sub-planes extend in a second direction intersecting the first direction. The first common source plate and the second common source plate are disposed apart from each other in the second direction. Each of the plurality of sub-planes includes a plurality of first memory blocks coupled with the first common source plate, and a plurality of second memory blocks coupled with the second common source plate.

The vertical direction (Z-axis direction) may be a third direction which is perpendicular to the first and second directions, and intersects the first and second directions. The first direction may be a Y-axis direction. The second direction may be a X-axis direction.

Additional aspects may be set forth in part in the description which follows and, in part, may be apparent from the description, and/or may be learned by practice of the presented embodiments.

At least some of the above and other features of the disclosure are set out in the claims.

### BRIEF DESCRIPTION OF DRAWINGS

The above and other aspects, features, and advantages of certain embodiments of the present disclosure may be more apparent from the following description taken in conjunction with the accompanying drawings, in which:
FIG. 1 is a block diagram illustrating a memory device, according to an embodiment;
FIG. 2 is a circuit diagram illustrating a memory block, according to an embodiment;
FIG. 3 schematically illustrates a structure of a memory device, according to an embodiment;
FIG. 4 schematically illustrates a memory device having a bonding vertical NAND (B-VNAND) structure, according to an embodiment;
FIG. 5 is a plan view illustrating a memory device, according to an embodiment;
FIG. 6 is a cross-sectional view taken along line Y1-Y2 of FIG. 5, according to an embodiment;
FIG. 7 is a cross-sectional view taken along line X1-X2 of FIG. 5, according to an embodiment;
FIG. 8 schematically illustrates a memory device having a B-VNAND structure, according to an embodiment;
FIG. 9 schematically illustrates a memory device having a B-VNAND structure, according to an embodiment;
FIG. 10 is a block diagram illustrating a memory device, according to an embodiment;
FIG. 11 schematically illustrates a memory device having a B-VNAND structure, according to an embodiment;
FIGS. 12 to 18 are plan views each illustrating a memory device, according to some embodiments;
FIG. 19 is a cross-sectional view of a memory device having a B-VNAND structure, according to an embodiment; and
FIG. 20 illustrates a solid state drive (SSD) including a memory device, according to an embodiment.

### DETAILED DESCRIPTION

The following description with reference to the accompanying drawings is provided to assist in a comprehensive understanding of embodiments of the present disclosure defined by the claims and their equivalents. Various specific details are included to assist in understanding, but these details are considered to be examples only. Therefore, those of ordinary skill in the art may recognize that various changes and modifications of the embodiments described herein may be made without departing from the scope of the disclosure. In addition, descriptions of well-known functions and structures are omitted for clarity and conciseness.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wired), wirelessly, or via a third element.

It is to be understood that when an element or layer is referred to as being "over," "above," "on," "below," "under," "beneath," "connected to" or "coupled to" another element or layer, it may be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

The terms "upper," "middle", "lower", and the like may be replaced with terms, such as "first," "second," third" to be used to describe relative positions of elements. The terms "first," "second," third" may be used to describe various elements but the elements are not limited by the terms and a "first element" may be referred to as a "second element". Alternatively or additionally, the terms "first", "second", "third", and the like may be used to distinguish components from each other and do not limit the present disclosure. For example, the terms "first", "second", "third", and the like may not necessarily involve an order or a numerical meaning of any form.

As used herein, when an element or layer is referred to as "covering", "overlapping", "overlaying", or "surrounding" another element or layer, the element or layer may cover at least a portion of the other element or layer, where the portion may include a fraction of the other element or may include an entirety of the other element. Similarly, when an element or layer is referred to as "penetrating" another element or layer, the element or layer may penetrate at least a portion of the other element or layer, where the portion may include a fraction of the other element or may include an entire dimension (e.g., length, width, depth) of the other element.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," "in some embodiments", "in certain embodiments", and similar language throughout this disclosure may, but do not necessarily, all refer to the same embodiment. The embodiments described herein are example embodiments, and thus, the disclosure is not limited thereto and may be realized in various other forms.

As used herein, each of the terms "SiN", "SiO", "TaN", "TiAlN", "TiN", "WN", and the like may refer to a material made of elements included in each of the terms and is not a chemical formula representing a stoichiometric relationship.

Hereinafter, various embodiments of the present disclosure are described with reference to the accompanying drawings.

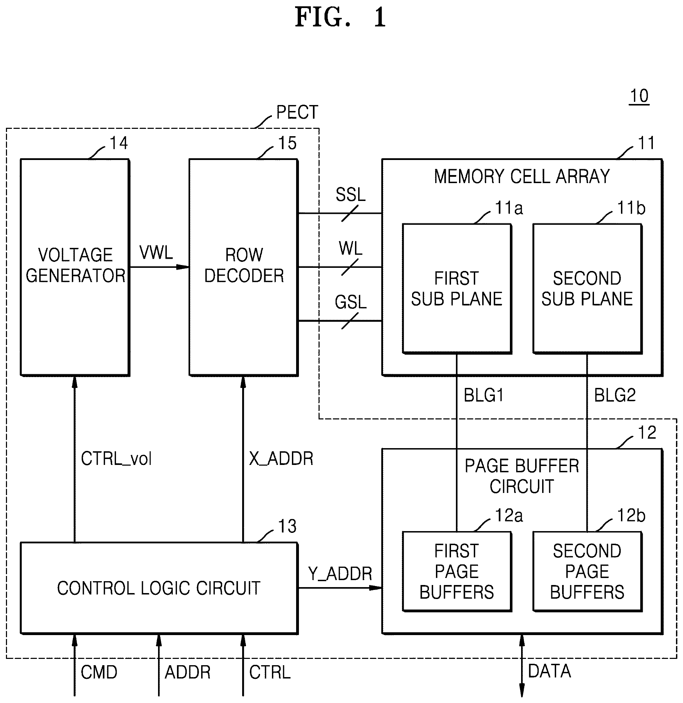

FIG. 1 is a block diagram illustrating a memory device, according to an embodiment.

Referring to FIG. 1, the memory device 10 may include a memory cell array 11 and a peripheral circuit PECT, and the peripheral circuit PECT may include a page buffer circuit 12, a control logic circuit 13, a voltage generator 14, and a row decoder 15. In some embodiments, the peripheral circuit PECT may further include data input/output (I/O) circuitry or an I/O interface. In addition, in some embodiments, the peripheral circuit PECT may further include a temperature sensor, a command decoder, an address decoder, or the like. As used herein, the memory device 10 may refer to a nonvolatile memory device.

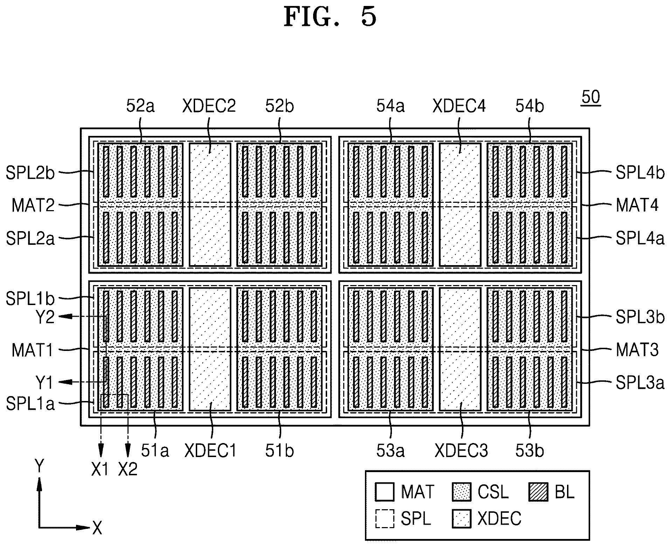

The memory cell array 11 may include a plurality of sub-planes including a first sub-plane 11a and a second sub-plane 11b. For example, the memory cell array 11 may include and/or may be similar in many respects to a memory array tile (MAT). In an embodiment, the memory cell array 11 may include and/or may be similar in many respects to a MAT as described with reference to FIG. 5. Alternatively or additionally, the memory cell array 11 may have a capacity of 16 kilobytes (KB). However, embodiments of the present disclosure are not limited thereto. As used herein, the memory cell array 11 may be referred to as a memory plane or as a plane.

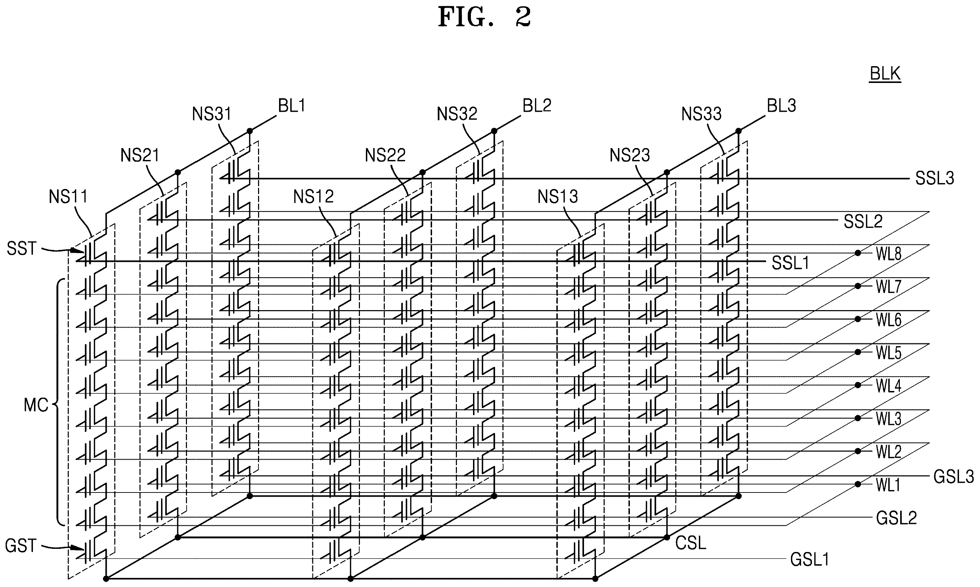

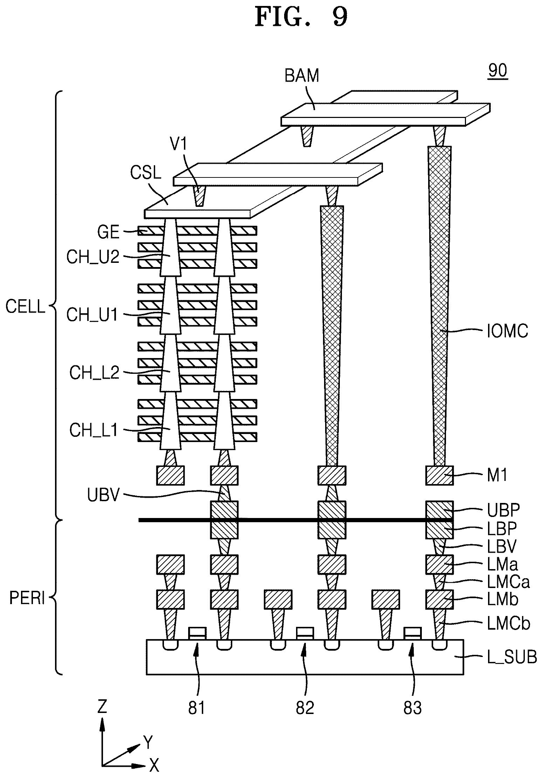

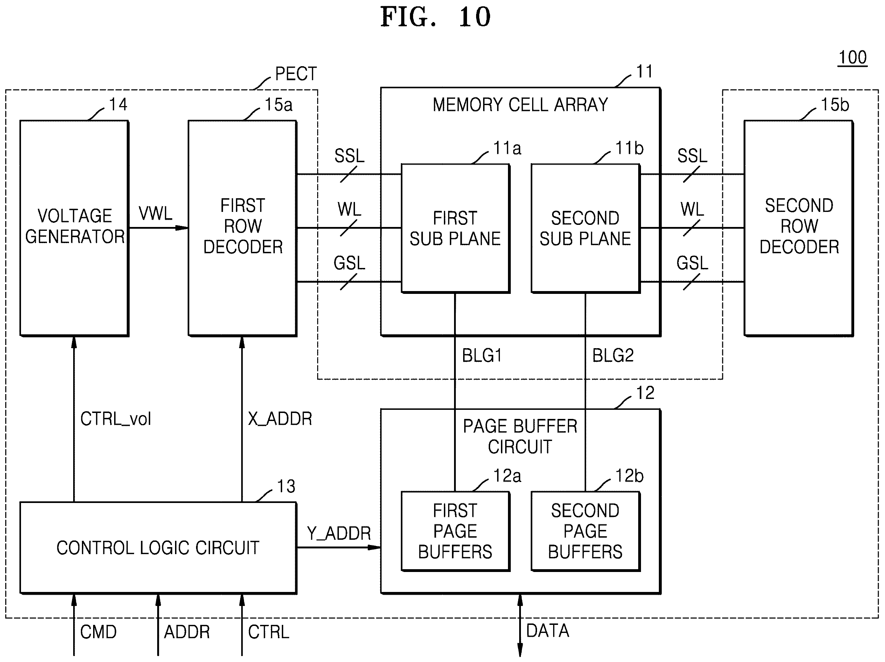

In an embodiment, the plurality of sub-planes 11a and 11b may each be arranged in a first direction (e.g., Y in FIG. 5) and may extend in a second direction (e.g., X in FIG. 5) intersecting the first direction. As used herein, the first direction may include and/or may be similar in many respects to an extension direction of bit lines. For example, each of the plurality of sub-planes 11a and 11b may have a capacity of 8 KB. However, embodiments of the present disclosure are not limited thereto. In an embodiment, each of the plurality of sub-planes 11a and 11b may include a plurality of memory blocks, and each memory block may include a plurality of memory cells, as described with reference to FIG. 2. In an embodiment, each of the plurality of memory blocks may include a plurality of memory stacks, as described with reference to FIGS. 9 and 10.

In an embodiment, the first sub-plane 11a may be connected to a first bit line group BLG1 including first bit lines each extending in the first direction Y, and the second sub-plane 11b may be connected to a second bit line group BLG2 including second bit lines each extending in the first direction Y. In such a manner, the first and second sub-planes 11a and 11b may be connected to the first and second bit line groups BLG1 and BLG2, respectively, and may be independently controlled.

In an embodiment, the memory device 10 may further include a first plate common source line (CSL) (e.g., a first common source plate 51a of FIG. 5) extending in the first direction Y, and some memory blocks included in the first sub-plane 11a and some memory blocks included in the second sub-plane 11b may be commonly connected to the first common source plate 51a (not shown in FIG. 1). In an embodiment, the memory device 10 may further include a second plate CSL (e.g., a second common source plate 51b of FIG. 5) (not shown in FIG. 1). The second common source plate 51b may extend in the first direction Y and may be disposed apart from the first common source plate 51a in the second direction X. The other (remaining) memory blocks included in the first sub-plane 11a and the other (remaining) memory blocks included in the second sub-plane 11b may be commonly connected to the second common source plate 51b. As used herein, the common source plate may refer to a common source line structure having a plate shape and commonly connected to a plurality of memory blocks.

The memory cell array 11 may be connected to the row decoder 15 through word lines WL, string select lines SSL, and ground select lines GSL. For example, the memory cells included in the memory cell array 11 may be and/or may include flash memory cells. Hereinafter, embodiments are described using an example in which the memory cells are NAND flash memory cells. However, embodiments of the present disclosure are not limited thereto. For example, in some embodiments, the memory cells may be and/or may include resistive memory cells, such as, but not limited to, resistive random access memory (ReRAM), phase change RAM (PRAM), magnetic RAM (MRAM), or the like.

In an embodiment, the memory cell array 11 may include a three-dimensional (3D) memory cell array. The 3D memory cell array may include a plurality of NAND strings, and each NAND string may include memory cells respectively connected to word lines vertically stacked on a substrate, as described with reference to FIG. 2. U.S. Patent No. 7,679,133, U.S. Patent No. 8,553,466, U.S. Patent No. 8,654,587, U.S. Patent No. 8,559,235, and U.S. Patent No. 9,536,970 disclose configurations of 3D memory arrays constructed with a plurality of levels and in which word lines and/or bit lines are shared between the plurality of levels, the disclosures of which are incorporated by reference herein in their entireties.

The page buffer circuit 12 may include a plurality of page buffers including first page buffers 12a and second page buffers 12b. The first page buffers 12a may be connected to the memory cells of the first sub-plane 11a through the first bit line group BLG1, and the second page buffers 12b may be connected to the memory cells of the second sub-plane 11b through the second bit line group BLG2. The page buffer circuit 12 may select at least one bit line from among a plurality of bit lines included in the first and second bit line groups BLG1 and BLG2 under control by the control logic circuit 13. For example, the page buffer circuit 12 may select some bit lines in response to a column address Y_ADDR received from the control logic circuit 13.

Each of the plurality of page buffers 12a and 12b may operate as a write driver and/or a sense amplifier. For example, during a program operation, each of the plurality of page buffers 12a and 12b may store data DATA in a memory cell by applying a voltage corresponding to data DATA to be programmed to a bit line. For example, during a program verify operation or a read operation, each of the plurality of page buffers 12a and 12b may detect programmed data DATA by detecting current and/or voltage through a bit line.

The control logic circuit 13 may output various control signals, such as, but not limited to, a voltage control signal CTRL_vol, a row address X_ADDR, and a column address Y_ADDR, for programming data to the memory cell array 11, reading data from the memory cell array 11, and/or erasing data stored in the memory cell array 11, based on a command CMD, an address ADDR, and a control signal CTRL. In such manner, the control logic circuit 13 may control various overall operations within the memory device 10. For example, the control logic circuit 13 may receive the command CMD, the address ADDR, and the control signal CTRL from a memory controller.

The voltage generator 14 may generate various types (e.g., levels) of voltages for performing program, read, and/or erase operations on the memory cell array 11, based on the voltage control signal CTRL_vol. In an embodiment, the voltage generator 14 may generate a word line voltage VWL, such as, but not limited to, a program voltage, a read voltage, a pass voltage, an erase verify voltage, a program verify voltage, or the like. In addition, the voltage generator 14 may further generate a string selection line voltage and/or a ground selection line voltage based on the voltage control signal CTRL _vol.

The row decoder 15 may select one of a plurality of memory blocks included in the plurality of sub-planes 11a and 11b, select one of the word lines WL of the selected memory block, and select one of the string selection lines SSL, in response to the row address X_ADDR received from the control logic circuit 13. For example, during a program operation, the row decoder 15 may apply a program voltage and/or a program verify voltage to a selected word line, and during a read operation, the row decoder 15 may apply a read voltage to a selected word line.

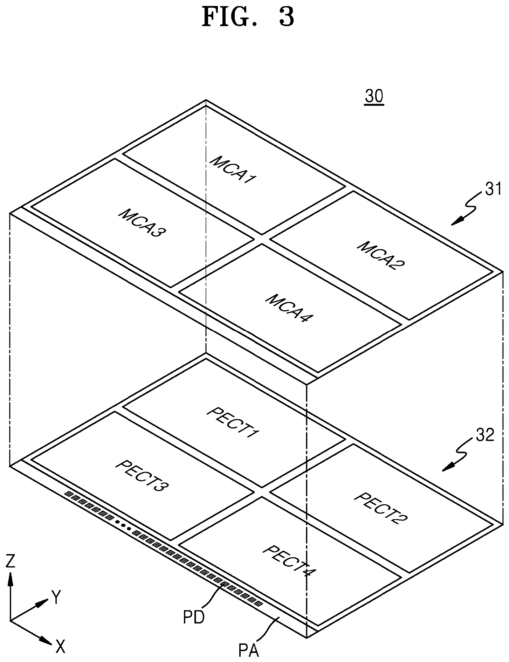

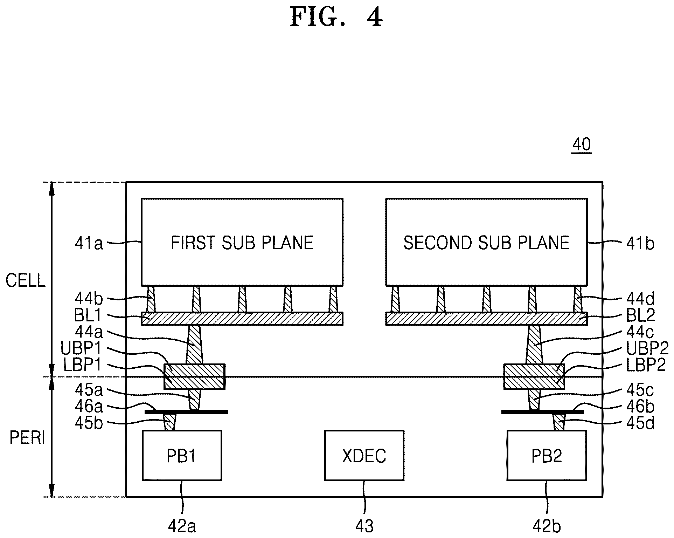

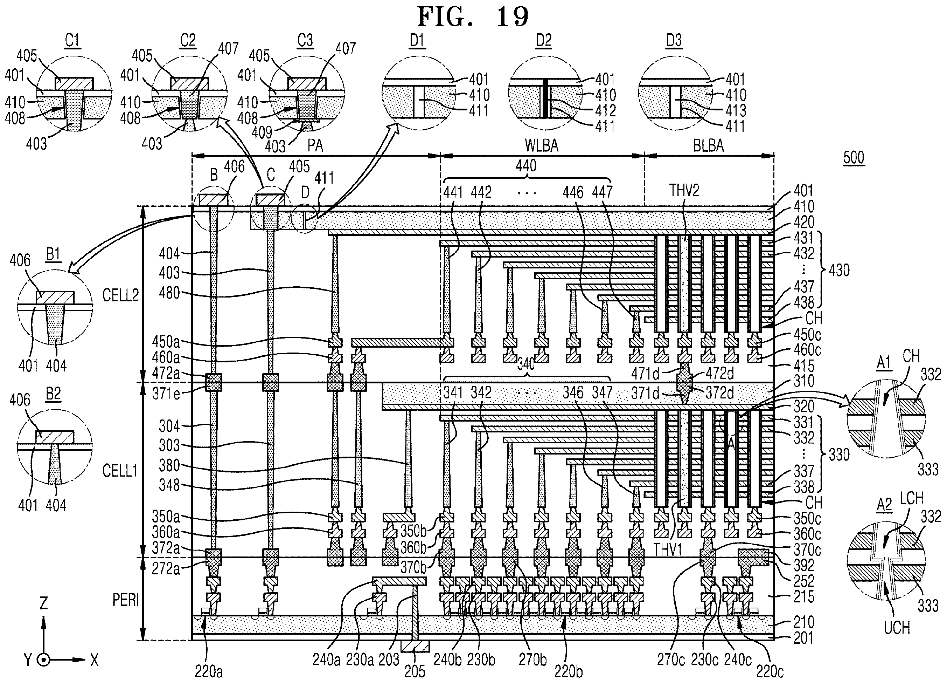

According to an embodiment, the memory cell array 11 may be placed in a memory cell region, a first semiconductor layer, a first wafer, a first semiconductor chip, or a memory chip (e.g., memory cell region 31 of FIG. 3, memory cell region CELL of FIGS. 4, 6, 7, 11, or memory cell regions CELL1 and CELL2 of FIG. 19), and the peripheral circuit PECT may be placed in a peripheral circuit region, a second semiconductor layer, a second wafer, a second semiconductor chip, or a peripheral circuit chip (e.g., peripheral circuit region 32 of FIG. 3 or peripheral circuit region PERI of FIGS. 4, 6, 7, 11, 19). Accordingly, at least a portion of the peripheral circuit PECT may overlap or overlay the memory cell array 11 in a vertical direction.

FIG. 2 is a circuit diagram illustrating a memory block BLK, according to an embodiment.

Referring to FIG. 2, the memory block BLK may include and/or may be similar in many respects to one of a plurality of memory blocks included in each of the plurality of sub-planes 11a and 11b described with reference to FIG. 1, and may include additional features not mentioned above. Consequently, repeated descriptions of the memory block BLK described above with reference to FIG. 1 may be omitted for the sake of brevity.

As shown in FIG. 2, the memory block BLK may include a plurality of NAND strings (e.g., a first NAND string NS11, a second NAND string NS21, a third NAND string NS31, a fourth NAND string NS12, a fifth NAND string NS22, a sixth NAND string NS32, a seventh NAND string NS13, an eighth NAND string NS23, and a ninth NAND stringNS33), and each NAND string (e.g., the first NAND string NS11) may include a string select transistor SST, a plurality of memory cells MC and a ground select transistor GST connected in series. Transistors SST and GST and memory cells MCs included in each NAND string may form a structure stacked in the vertical direction on a substrate.

A plurality of bit lines (e.g., a first bit line BL1, a second bit line BL2, and a third bit line BL3) may extend in the first direction (e.g., the Y direction in FIG. 3), and a plurality of word lines (e.g., a first word line WL1, a second word line WL2, a third word line WL3, a fourth word line WL4, a fifth word line WL5, a sixth word line WL6, a seventh word line WL7, and an eighth word line WL8) may extend in the second direction (e.g., the X direction in FIG. 3). According to an embodiment, the first direction may be referred to as a first horizontal direction, and the second direction may be referred to as a second horizontal direction. The first to third NAND strings NS11 to NS31 may be positioned between the first bit line BL1 and a common source line CSL, fourth to sixth NAND strings NS12 to NS32 may be positioned between the second bit line BL2 and the common source line CSL, and seventh to ninth NAND strings NS13 to NS33 may be positioned between the third bit line BL3 and the common source line CSL. For example, the first to third bit lines BL1 to BL3 may be included in the first bit line group BLG1 or the second bit line group BLG2 of FIG. 1.

A string select transistor SST may be connected to a corresponding string select line (e.g., a first string select line SSL1, a second string select line SSL2, and a third string select line SSL3). The memory cells MCs may be respectively connected to corresponding word lines of the plurality of word lines WL1 to WL8. A ground select transistor GST may be connected to a corresponding one of ground select lines (e.g., a first ground select line GSL1, a second ground select line GSL2, and a third ground select line GSL3). The string select transistor SST may be connected to a corresponding bit line, and the ground select transistor GST may be connected to the common source line CSL. Although FIG. 2 illustrates particular numbers of first to ninth NAND strings NS11 to NS33, first to eighth word lines WL1 to WL8, first to third bit lines BL1 to BL3, first to third ground select lines GSL1 to GSL3, and first to third string select lines SSL1 to SSL3, embodiments of the present disclosure are not limited thereto. For example, the number of NAND strings, the number of word lines, the number of bit lines, the number of ground select lines, and the number of string select lines may vary according to an embodiment and/or design constraints.

FIG. 3 schematically illustrates a structure of a memory device, according to an embodiment.

Referring to FIG. 3, a memory device 30 may include a memory cell region 31 and a peripheral circuit region 32. The memory device 30 of FIG. 3 may include and/or may be similar in many respects to the memory device 10 described above with reference to FIGS. 1 and 2, and may include additional features not mentioned above. Furthermore, the memory cell region 31 and the peripheral circuit region 32 of FIG. 3 may include and/or may be similar in many respects to memory cell array 11 and the peripheral circuit PECT described above with reference to FIG. 1, respectively, and may include additional features not mentioned above. Consequently, repeated descriptions of the memory device 30, the memory cell region 31, and the peripheral circuit region 32 described above with reference to FIGS. 1 and 2 may be omitted for the sake of brevity.

The memory cell region 31 may be formed on a first wafer and may be referred to as a memory chip or as a first semiconductor chip. The peripheral circuit region 32 may be formed on a second wafer and may be referred to as a peripheral circuit chip or as a second semiconductor chip. In an embodiment, the memory cell region 31 and the peripheral circuit region 32 may be connected in the vertical direction Z by a bonding manner, and accordingly, the memory device 30 may be referred to as a memory device of a bonding vertical NAND (B-VNAND) type or a chip-to-chip (C2C) bonding structure.

In an embodiment, the memory cell region 31 may include a plurality of memory cell arrays (e.g., a first memory cell array MCA1, a second memory cell array MCA2, a third memory cell array MCA3, and a fourth memory cell array MCA4). For example, at least one of the plurality of memory cell arrays MCA1 to MCA4 may include and/or may be similar in many respects to the memory cell array 11 of FIG. 1. As used herein, each of the plurality of memory cell arrays MCA1 to MCA4 may be referred to as a memory plane or MAT, and accordingly, the memory cell region 31 may be referred to as having a 4-MAT structure. The peripheral circuit region 32 may include a plurality of peripheral circuits (e.g., a first peripheral circuit PECT1, a second peripheral circuit PECT2, a third peripheral circuit PECT3, and a fourth peripheral circuit PECT4) corresponding to plurality of memory cell arrays MCA1 to MCA4, respectively. In addition, the peripheral circuit region 32 may further include a pad region (or an external pad bonding region) PA in which a plurality of pads PD may be arranged.

In an embodiment, each of the plurality of memory cell arrays MCA1 to MCA4 may include a plurality of sub-planes arranged in the first direction Y, and each sub-plane may extend in the second direction X. In an embodiment, each of the plurality of memory cell arrays MCA1 to MCA4 may further include a common source plate extending in the first direction Y and commonly connected to a plurality of sub-planes and a plurality of bit line groups respectively connected to the plurality of sub-planes. The peripheral circuit region 32 may include a plurality of page buffers respectively connected to a plurality of bit line groups.

In an embodiment, each sub-plane of the plurality of sub-planes may include a plurality of memory blocks and a plurality of word line groups. For example, the plurality of memory blocks may include first to fourth memory blocks, and the plurality of word line groups may include a first word line group commonly connected to the first and second memory blocks and a second word line group commonly connected to the third and fourth memory blocks. As another example, the plurality of memory blocks may include first to fourth memory blocks, and the plurality of word line groups may include a first word line group connected to the first memory block, a second word line group connected to the second memory block, a third word line group connected to the third memory block, and a fourth word line group connected to the fourth memory block.

FIG. 4 schematically illustrates a memory device having a B-VNAND structure, according to an embodiment.

Referring to FIG. 4, a memory device 40 may include a memory cell region CELL and a peripheral circuit region PERI. The memory device 40 of FIG. 4 may include and/or may be similar in many respects to the memory devices 10 and 30 described above with reference to FIGS. 1 to 3, and may include additional features not mentioned above. Furthermore, the memory cell region CELL of FIG. 4 may include and/or may be similar in many respects to memory cell array 11 and the memory cell region 31 described above with reference to FIGS. 1 to 3, and may include additional features not mentioned above. In addition, the peripheral circuit region PERI may include and/or may be similar in many respects to peripheral circuit PECT and the peripheral circuit region 32 described above with reference to FIGS. 1 to 3, and may include additional features not mentioned above. Consequently, repeated descriptions of the memory device 40, the memory cell region CELL, and the peripheral circuit region PERI described above with reference to FIGS. 1 to 3 may be omitted for the sake of brevity.

The memory cell region CELL may include a first sub-plane 41a, a second sub-plane 41b, a first upper bonding pad UBP1, and a second upper bonding pad UBP2. In the memory cell region CELL, the first upper bonding pad UBP1 may be connected to the first bit line BL1 through a first via 44a, and the first bit line BL1 may be connected to the first sub-plane 41a through a second via 44b. In the memory cell region CELL, the second upper bonding pad UBP2 may be connected to a second bit line BL2 through a third via 44c, and the second bit line BL2 may be connected to a second sub-plane 41b through a fourth via 44d. In an embodiment, the first and second sub-planes 41a and 41b of FIG. 4 may include and/or may be similar in many respects to the first and second sub-planes 11a and 11b described above with reference to FIG. 1, respectively. For example, the first bit line BL1 may be included in the first bit line group BLG1 of FIG. 1, and the second bit line BL2 may be included in the second bit line group BLG2 of FIG. 1.

The peripheral circuit region PERI may include a first page buffer PB1 42a, a second page buffer PB2 42b, a row decoder XDEC 43, and lower bonding pads (e.g., a first lower bonding pad LBP1 and a second lower bonding pad LBP2). In the peripheral circuit region PERI, the lower bonding pad LBP1 may be connected to the first page buffer 42a, and the lower bonding pad LBP2 may be connected to the second page buffer 42b. For example, the lower bonding pad LBP1 may be connected to the first page buffer 42a through first and second vias 45a and 45b and a lower metal layer 46a. As another example, the lower bonding pad LBP2 may be connected to the second page buffer 42b through third and fourth vias 45c and 45d and a lower metal layer 46b. The first page buffer 42a may include and/or may be similar in many respects to one of the first page buffers 12a of FIG. 1, and the second page buffer 42b may include and/or may be similar in many respects to one of the second page buffers 12b of FIG. 1.

FIG. 5 is a plan view illustrating a memory device, according to an embodiment.

Referring to FIG. 5, the memory device 50 may include a plurality of MATs (e.g., a first MAT MAT1 and a second MAT MAT2 arranged in the first direction Y, and a third MAT MAT3 and a fourth MAT MAT4 arranged in the first direction Y). In an embodiment, the first and third MATs MAT1 and MAT3 may be apart from each other in the second direction X, and the second and fourth MATs MAT2 and MAT4 may be apart from each other in the second direction X. In such a manner, the plurality of MATs MAT1 to MAT4 may be arranged in a 2×2 array form.

Each of the plurality of MATs MAT1 to MAT4 of FIG. 5 may include and/or may be similar in many respects to the memory cell array 11 of FIGS. 1 and 2, the memory cell region 31 of FIG. 3, and the memory cell region CELL of FIG. 4, and may include additional features not mentioned above. Consequently, repeated descriptions of the plurality of MATs described above with reference to FIGS. 1 to 4 may be omitted for the sake of brevity.

The first MAT MAT1 may include a plurality of sub-planes (e.g., a first sub-plane SPL1a and a second sub-plane SPL1b) arranged in the first direction Y. For example, each of the plurality of sub-planes SPL1a and SPL1b may extend in the second direction X. The plurality of sub-planes SPL1a and SPL1b may include and/or may be similar in many respects to the plurality of sub-planes 11a and 11b of FIG. 1, respectively, and may include additional features not mentioned above. In an embodiment, by arranging the first and second sub-planes SPL1a and SPL1b in the first direction Y, the aspect ratio of the region in which the first MAT MAT1 is formed may be improved, when compared to related nonvolatile memory devices.

A cut region (e.g., a tile cut region) may not be disposed between the plurality of sub-planes SPL1a and SPL1b. For example, an I/O contact plug may not be placed in the region between the first and second sub-planes SPL1a and SPL1b. Accordingly, the size of the first MAT MAT1 may be reduced, and the number of memory dies formed per wafer (e.g., a gross die (GD) value) may increase.

The first MAT MAT1 may further include bit lines BL connected to the first sub-plane SPL1a and bit lines BL connected to the second sub-plane SPL1b, and the bit lines BL may extend in the first direction Y and be spaced apart from each other in the second direction X. For example, the bit lines BL connected to the first sub-plane SPL1a may include and/or may be similar in many respects to the first bit line group BLG1 of FIG. 1, and the bit lines BL connected to the second sub-plane SPL1b may include and/or may be similar in many respects to the second bit line group BLG2 of FIG. 1. In such a manner, as the first and second sub-planes SPL1a and SPL1b are connected to the first and second bit line groups BLG1 and BLG2, respectively, and the page buffers are placed below the first and second sub-planes SPL1a and SPL1b, the read time of the memory device 50 may be reduced, thereby potentially improving the performance of the memory device 50, when compared to related nonvolatile memory devices.

The first MAT MAT1 may further include a plurality of common source plates (e.g., a first common source plate 51a and a second common source plate 51b). The plurality of common source plates 51a and 51b may each extend in the first direction Y and be apart from each other in the second direction X. The memory device 50 may further include the row decoder XDEC1 connected to the first MAT MAT1. For example, the row decoder XDEC1 may be disposed under a region between the first and second common source plates 51a and 51b. For example, the first and second sub-planes SPL1a and SPL1b, the first and second common source plates 51a and 51b, and the bit lines BL may be arranged in the memory cell region CELL of FIG. 4, and the row decoder XDEC1 may be arranged in the peripheral circuit region PERI of FIG. 4.

In an embodiment, the row decoder XDEC1 may include a first row decoder connected to the first sub-plane SPL1a and a second row decoder connected to the second sub-plane SPL1b. In such a manner, the first and second sub-planes SPL1a and SPL1b may be connected to different row decoders, respectively. Accordingly, word lines connected to the first and second sub-planes SPL1a and SPL1b may be independently controlled. In an embodiment, a first pass transistor circuit may be connected between the row decoder XDEC1 and the first sub-plane SPL1a, and a second pass transistor circuit may be connected between the row decoder XDEC1 and the second sub-plane SPL1b. In such a manner, the first and second sub-planes SPL1a and SPL1b may be respectively connected to the different pass transistor circuits. Accordingly, word lines connected to the first and second sub-planes SPL1a and SPL1b may be independently controlled.

The first sub-plane SPL1a may include first memory blocks connected to the first common source plate 51a and second memory blocks connected to the second common source plate 51b. The second sub-plane SPL1b may include third memory blocks connected to the first common source plate 51a and fourth memory blocks connected to the second common source plate 51b. In an embodiment, the row decoder XDEC1 may include a first row decoder disposed under a region between the first memory blocks and the second memory blocks and a second row decoder disposed under a region between the third memory blocks and the fourth memory blocks. In an embodiment, the first pass transistor circuit may be arranged between the first memory blocks and the row decoder XDEC1, and the second pass transistor circuit may be arranged between the second memory blocks and the row decoder XDEC1.

The second MAT MAT2 may include first and second sub-planes SPL2a and SPL2b arranged in the first direction Y, bit lines BL respectively connected to the first and second sub-planes SPL2a and SPL2b, and first and second common source plates 52a and 52b, and the memory device 50 may further include a row decoder XDEC2 connected to the second MAT MAT2. The third MAT MAT3 may include first and second sub-planes SPL3a and SPL3b arranged in the first direction Y, bit lines BL respectively connected to the first and second sub-planes SPL3a and SPL3b, and first and second common source plates 53a and 53b, and the memory device 50 may further include a row decoder XDEC3 connected to the third MAT MAT3. The fourth MAT MAT4 may include first and second sub-planes SPL4a and SPL4b arranged in the first direction Y, bit lines BL respectively connected to the first and second sub-planes SPL4a and SPL4b, and first and second common source plates 54a and 54b, and the memory device 50 may further include a row decoder XDEC4 connected to the fourth MAT MAT4. The description given above for the first MAT MAT1 may be applied to the second to fourth MATs MAT2 to MAT4.

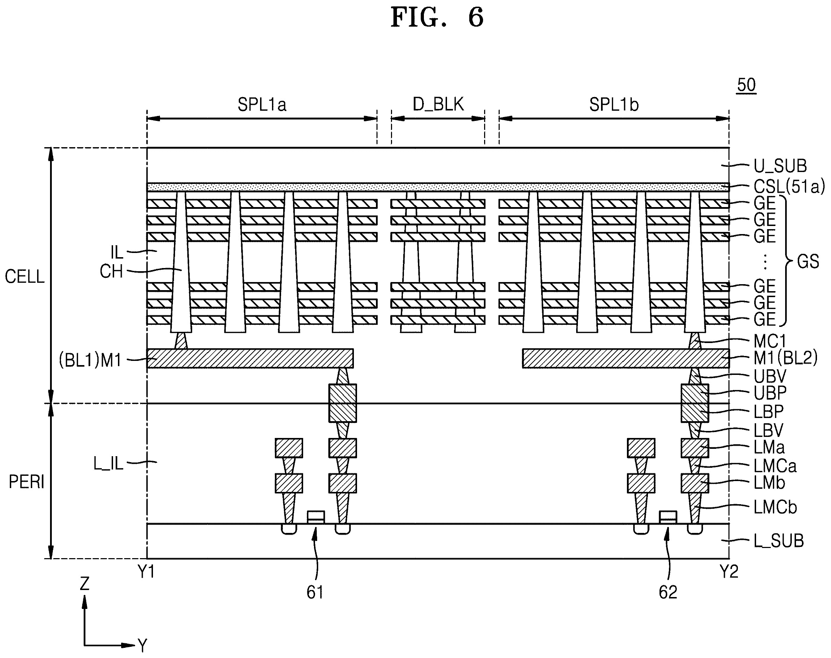

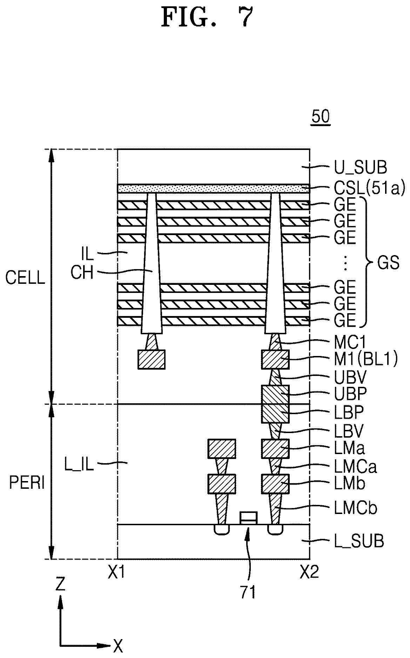

FIG. 6 is a cross-sectional view taken along line Y1-Y2 of FIG. 5, according to an embodiment. FIG. 7 is a cross-sectional view taken along line X1-X2 of FIG. 5, according to an embodiment.

Referring to FIGS. 6 and 7 together, the memory cell region CELL may include the first sub-plane SPL1a and the second sub-plane SPL1b, and a dummy block D_BLK may be placed between the first and second sub-planes SPL1a and SPL1b. For example, the dummy block D_BLK may not be connected to a bit line or metal layer. For example, the dummy block D_BLK may be floated. However, embodiments of the present disclosure are not limited thereto. For example, according to an embodiment, a cut region, (e.g., a tile cut region) may not be placed between the first and second sub-planes SPL1a and SPL1b. As another example, I/O contact plugs may not be arranged between the first and second sub-planes SPL1a and SPL1b, thereby reducing the size of the memory cell region CELL, when compared to related nonvolatile memory devices.

For example, the first and second sub-planes SPL1a and SPL1b and the dummy block D_BLK may be commonly connected to the first common source plate 51a. As another example, the first and second sub-planes SPL1a and SPL1b may be connected to different bit lines BL1 and BL2, respectively. Alternatively or additionally, the first and second sub-planes SPL1a and SPL1b and the dummy block D_BLK may be respectively connected to different gate electrodes GE. However, embodiments of the present disclosure are not limited thereto. For example, in an embodiment, the first and second sub-planes SPL1a and SPL1b and the dummy block D_BLK may be connected to the same gate electrodes GE.

The memory cell region CELL may include an upper substrate U_SUB, a first common source plate 51a, a gate structure GS, channel structures CH, an insulating layer IL, a first metal layer M1, first metal contacts MC1, upper bonding vias UBV, and upper bonding pads UBP. The number of metal layers included in the memory cell region CELL may vary according to an embodiment and/or design constraints. The upper substrate U_SUB may be implemented with polysilicon. For example, the first common source plate 51a may be formed in a plate shape by doping impurities into the upper substrate U_SUB. According to an embodiment, the upper substrate U_SUB may be defined as including a plate common source line and/or a common source plate. The gate structure GS may include a plurality of gate electrodes GE stacked in the vertical direction Z, and the insulating layer IL may be placed between adjacent gate electrodes GE. The channel structures CH may extend from the upper substrate U_SUB or the first common source plate 51a in the vertical direction Z.

The first metal layer M1, the upper bonding vias UBV, and the upper bonding pads UBP may include a metal material, such as, but not limited to, copper (Cu), aluminum (Al), tungsten (W), titanium (Ti), titanium nitride (TiN), tungsten nitride (WN), tantalum (Ta), tantalum nitride (TaN), and titanium-aluminum-nitride (TiAlN), or combinations thereof. The first metal contact MC1 may include a conductive material, such as, but not limited to, doped polysilicon or aluminum (Al), tungsten (W), copper (Cu), titanium (Ti), or the like.

According to an embodiment, the first metal layer M1 may include bit lines BL1 and BL2 each extending in the first direction Y and be apart from each other in the second direction X. In an embodiment, the bit lines BL1 and BL2 may be respectively connected to the channel structures CH via corresponding metal contacts MC1 or drains. In addition, the bit lines BL1 and BL2 may be respectively connected to upper bonding pads UBP through corresponding upper bonding vias UBV.

The peripheral circuit region PERI may include a lower substrate L_SUB, lower metal layers (e.g., a first lower metal layer LMa and a second lower metal layer LMb), lower metal contacts (e.g., a first lower metal contact LMCa and a second lower metal contact LMCb), a lower insulating layer L_IL, lower bonding vias LBV, and lower bonding pads LBP. The number of lower metal layers included in the peripheral circuit region PERI may vary according to an embodiment and/or design constraints. A plurality of circuit devices (e.g., a first transistor 61, a second transistor 62, and a third transistor 71) may be arranged on the lower substrate L_SUB. For example, the first and third transistors 61 and 71 may be included in the first page buffer 42a of FIG. 4, and the second transistor 62 may be included in the second page buffer 42b of FIG. 4.

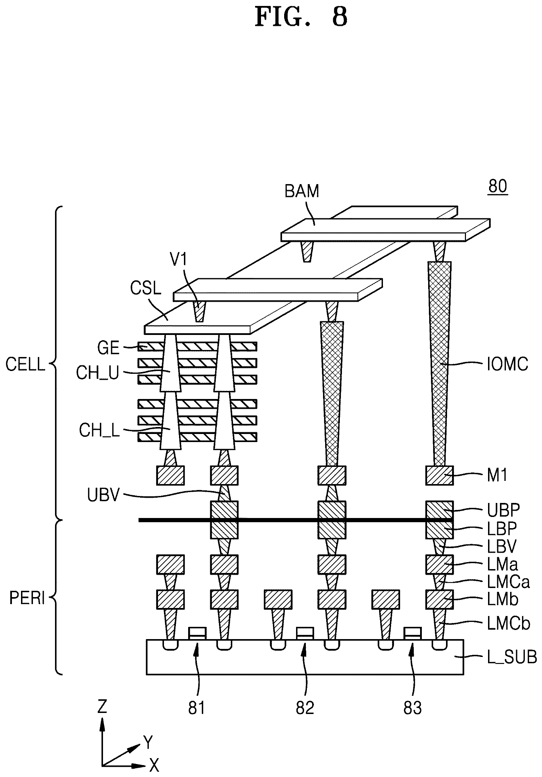

FIG. 8 schematically illustrates a memory device having a B-VNAND structure, according to an embodiment.

Referring to FIG. 8, a memory device 80 may include a memory cell region CELL and a peripheral circuit region PERI. The memory device 80 of FIG. 8 may include and/or may be similar in many respects to the memory devices 10, 30, 40, and 50 described above with reference to FIGS. 1 to 7, and may include additional features not mentioned above. Furthermore, the memory cell region CELL of FIG. 8 may include and/or may be similar in many respects to memory cell array 11, the memory cell region 31, and the memory cell region CELL described above with reference to FIGS. 1 to 7, and may include additional features not mentioned above. In addition, the peripheral circuit region PERI may include and/or may be similar in many respects to peripheral circuit PECT, the peripheral circuit region 32, and the peripheral circuit region PERI described above with reference to FIGS. 1 to 7, and may include additional features not mentioned above. Consequently, repeated descriptions of the memory device 80, the memory cell region CELL, and the peripheral circuit region PERI described above with reference to FIGS. 1 to 7 may be omitted for the sake of brevity.

The peripheral circuit region PERI may include a plurality of transistors (e.g., a first transistor 81, a second transistor 82, and a third transistor 83). For example, the first transistor 81 may be connected to a bit line and thus included in a page buffer. As another example, the second and third transistors 82 and 83 may be connected to a common source line CSL, and thereby, may be included in a common source line driver.

The memory cell region CELL may include a plurality of channel structures and a plurality of gate electrodes GE. Each channel structure may include first and second memory stacks CH_L and CH_U stacked in the vertical direction Z. A plurality of channel structures may be commonly connected to the common source line CSL. In an embodiment, the common source line CSL may be implemented as a common source plate and/or as a common source plate extending in the first direction Y.

A plurality of vias V1 may be arranged on the common source line CSL, and an upper metal layer BAM may be placed on the plurality of vias V1. For example, the upper metal layer BAM may correspond to a backside aluminum metal placed on the backside of an upper substrate. The memory cell region CELL may further include I/O metal contacts and/or I/O contact plugs IOMC. The upper bonding pads UBP may be connected to the common source line CSL through an upper bonding via UBV, a first metal layer M1, I/O contact plugs IOMC, a plurality of vias V1, and an upper metal layer BAM.

FIG. 9 schematically illustrates a memory device having a B-VNAND structure, according to an embodiment.

Referring to FIG. 9, a memory device 90 may include a memory cell region CELL and a peripheral circuit region PERI. The memory device 90 of FIG. 9 may include and/or may be similar in many respects to the memory devices 10, 30, 40, 50, and 80 described above with reference to FIGS. 1 to 8, and may include additional features not mentioned above. Furthermore, the memory cell region CELL of FIG. 9 may include and/or may be similar in many respects to memory cell array 11, the memory cell region 31, and the memory cell region CELL described above with reference to FIGS. 1 to 8, and may include additional features not mentioned above. In addition, the peripheral circuit region PERI may include and/or may be similar in many respects to peripheral circuit PECT, the peripheral circuit region 32, and the peripheral circuit region PERI described above with reference to FIGS. 1 to 8, and may include additional features not mentioned above. Consequently, repeated descriptions of the memory device 90, the memory cell region CELL, and the peripheral circuit region PERI described above with reference to FIGS. 1 to 8 may be omitted for the sake of brevity. Hereinafter, differences between the memory device 90 and the memory device 80 of FIG. 8 are mainly described.

The memory cell region CELL may include a plurality of channel structures, and each channel structure may include a plurality of memory stacks (e.g., a first memory stack CH_L1, a second memory stack CH_L2, a third memory stack CH_U1, and a fourth memory stack CH_U2) stacked in the vertical direction Z. The plurality of channel structures may be commonly connected to the common source line CSL. In an embodiment, the common source line CSL may be implemented as a common source plate extending in the first direction Y. In addition, a plurality of channel structures may be connected to a plurality of gate electrodes GE.

FIG. 10 is a block diagram illustrating a memory device, according to an embodiment.

Referring to FIG. 10, a memory device 100 may include a memory cell array 11 and a peripheral circuit PECT, and the peripheral circuit PECT may include a page buffer circuit 12, a control logic circuit 13, a voltage generator 14, and first and second row decoders 15a and 15b.

The memory device 100 of FIG. 10 may include and/or may be similar in many respects to the memory devices 10, 30, 40, 50, 80, and 90 described above with reference to FIGS. 1 to 9, and may include additional features not mentioned above. Consequently, repeated descriptions of the memory device 100 described above with reference to FIGS. 1 to 9 may be omitted for the sake of brevity. Hereinafter, differences between the memory device 100 and the memory device 10 of FIG. 1 are described.

The memory cell array 11 may include a plurality of sub-planes including a first sub-plane 11a and a second sub-plane 11b. The first sub-plane 11a may be connected to the first row decoder 15a, and the second sub-plane 11b may be connected to the second row decoder 15b. In such a manner, the first and second sub-planes 11a and 11b may be respectively connected to the first and second row decoders 15a and 15b and thus independently controlled. For example, the first sub-plane 11a may be connected to the first row decoder 15a via word lines WL, string select lines SSL, and ground select lines GSL, and the second sub-plane 11b may be connected to the second row decoder 15b via word lines WL, string select lines SSL, and ground select lines GSL.

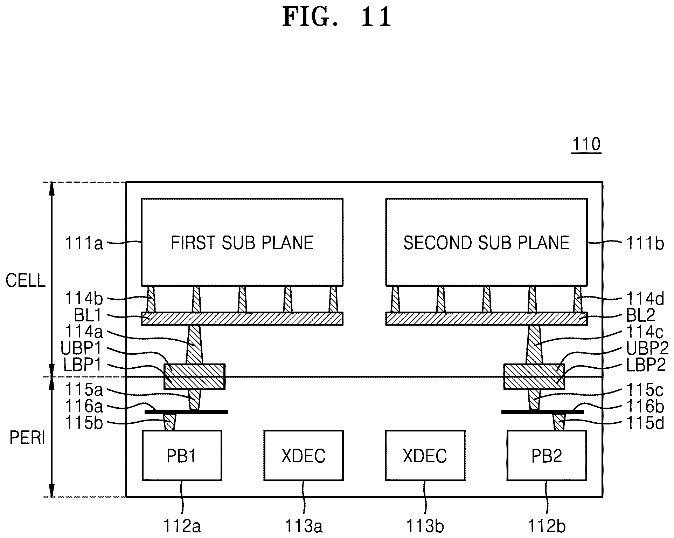

FIG. 11 schematically illustrates a memory device having a B-VNAND structure, according to an embodiment.

Referring to FIG. 11, a memory device 110 may include a memory cell region CELL and a peripheral circuit region PERI. The memory device 110 of FIG. 11 may include and/or may be similar in many respects to the memory devices 10, 30, 40, 50, 80, 90, and 100 described above with reference to FIGS. 1 to 10, and may include additional features not mentioned above. Consequently, repeated descriptions of the memory device 110 described above with reference to FIGS. 1 to 10 may be omitted for the sake of brevity.

The memory cell region CELL may include first and second sub-planes 111a and 111b and upper bonding pads UBP1 and UBP2. In the memory cell region CELL, the upper bonding pad UBP1 may be connected to the first bit line BL1 through a via 114a, and the first bit line BL1 may be connected to the first sub-plane 111a through a via 114b. In the memory cell region CELL, the upper bonding pad UBP2 may be connected to a second bit line BL2 through a via 114c, and the second bit line BL2 may be connected to the second sub-plane 111b through a via 114d. For example, the first and second sub-planes 111a and 111b may include and/or may be similar in many respects to the first and second sub-planes 11a and 11b of FIG. 10, respectively. For example, the first bit line BL1 may be included in the first bit line group BLG1 of FIG. 10, and the second bit line BL2 may be included in the second bit line group BLG2 of FIG. 10.

The peripheral circuit region PERI may include a first page buffer PB1 112a, a second page buffer PB2 112b, a plurality of row decoders (e.g., a first row decoder 113a and a second row decoder 113b), and a plurality of lower bonding pads (e.g., a first lower bonding pad LBP1 and a second lower bonding pad LBP2). In the peripheral circuit region PERI, the lower bonding pad LBP1 may be connected to the first page buffer 112a, and the lower bonding pad LBP2 may be connected to the second page buffer 112b. For example, the lower bonding pad LBP1 may be connected to the first page buffer 112a through first and second vias 115a and 115b and a lower metal layer 116a. For example, the lower bonding pad LBP2 may be connected to the second page buffer 112b through third and fourth vias 115c and 115d and a lower metal layer 116b. For example, the first page buffer 112a may include and/or may be similar in many respects to one of the first page buffers 12a of FIG. 10, and the second page buffer 112b may include and/or may be similar in many respects to one of the second page buffers 12b of FIG. 10

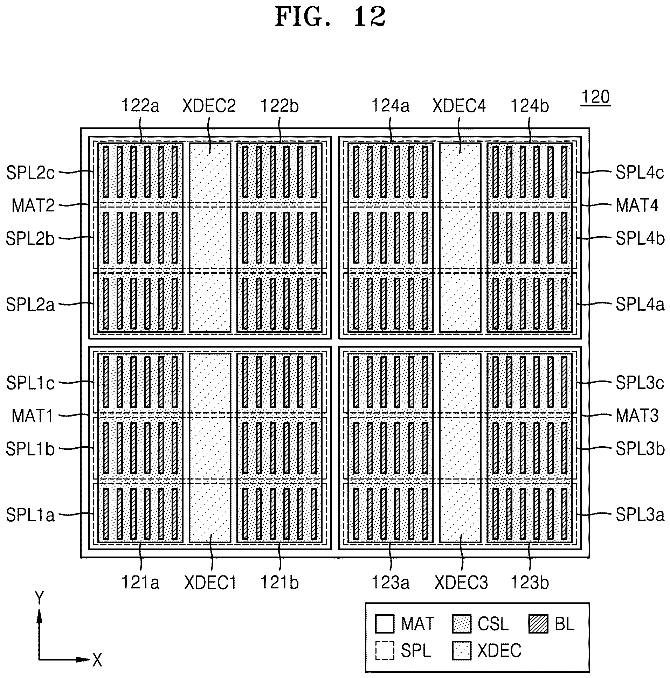

FIG. 12 is a plan view illustrating a memory device, according to an embodiment.

Referring to FIG. 12, a memory device 120 may include a plurality of MATs (e.g., a first MAT MAT1 and a second MAT MAT2 arranged in the first direction Y, and a third MAT MAT3 and a fourth MAT MAT4 arranged in the first direction Y). In an embodiment, the first and third MATs MAT1 and MAT3 may be apart from each other in the second direction X, and the second and fourth MATs MAT2 and MAT4 may be apart from each other in the second direction X. In such a manner, the first to fourth MATs MAT1 to MAT4 may be arranged in a 2×2 array form. For example, each of the plurality of MATs MAT1 to MAT4 may include and/or may be similar in many respects to the memory cell array 11 of FIGS. 1 or 10.

The memory device 120 may include and/or may be similar in many respects to a modified example of the memory device 50 of FIG. 5, and the description given above with reference to FIG. 5 may also be applied to the present embodiment. In an embodiment, each of the plurality of MATs MAT1 to MAT4 may include three (3) sub-planes. For example, the first MAT MAT1 may include a plurality of sub-planes (e.g., a first sub-plane SPL1a, a second sub-plane SPL1b, and a third sub-plane SPL1c), bit lines BL respectively connected to the plurality of sub-planes SPL1a to SPL1c, and a plurality of common source plates (e.g., a first common source plate 121a and a second common source plate 121b). The memory device 120 may further include a row decoder XDEC1 connected to the first MAT MAT1.

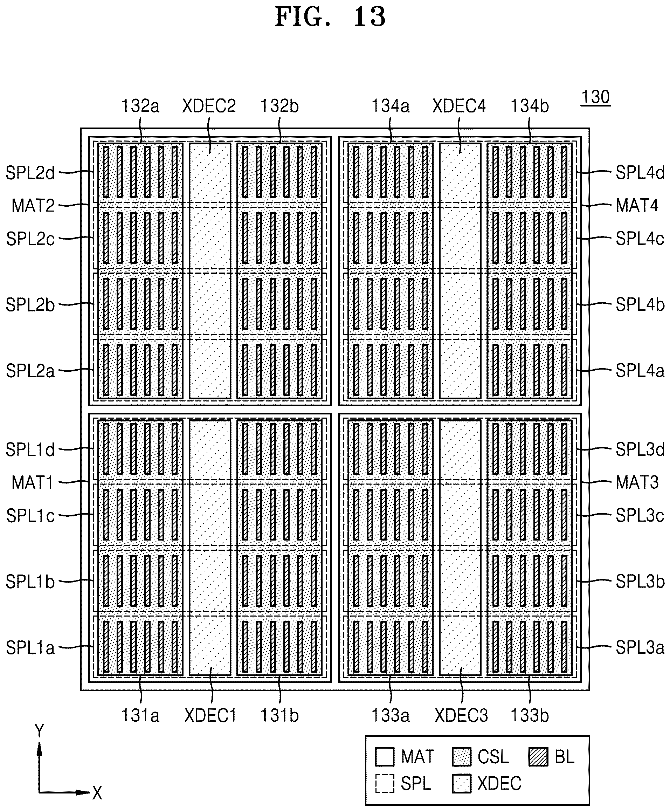

FIG. 13 is a plan view illustrating a memory device, according to an embodiment.

Referring to FIG. 13, a memory device 130 may include a plurality of MATs (e.g., a first MAT MAT1 and a second MAT MAT2 arranged in the first direction Y, and a third MAT MAT3 and a fourth MAT MAT4 arranged in the first direction Y). In an embodiment, the first and third MATs MAT1 and MAT3 may be adjacent in the second direction X, and the second and fourth MATs MAT2 and MAT4 may be adjacent in the second direction X. In such a manner, the first to fourth MATs MATI1 to MAT4 may be arranged in a 2×2 array form. For example, each of the plurality of MATs MAT1 to MAT4 may include and/or may be similar in many respects to the memory cell array 11 of FIGS. 1 or 10.

The memory device 130 may include and/or may be similar in many respects to a modified example of the memory device 120 of FIG. 12, and the description given above with reference to FIG. 12 may also be applied to the memory device 130. In an embodiment, each of the plurality of MATs MAT1 to MAT4 may include four (4) sub-planes. For example, the first MAT MAT1 may include a plurality of sub-planes (e.g., a first sub-plane SPL1a, a second sub-plane SPL1b, a third sub-plane SPL1c, and a fourth sub-plane SPL1d), bit lines BL respectively connected to the plurality of sub-planes SPL1a to SPL1d, and a plurality of common source plates (e.g., a first common source plate 131a and a second common source plate 131b). The memory device 130 may further include a row decoder XDEC1 connected to the first MAT MAT1.

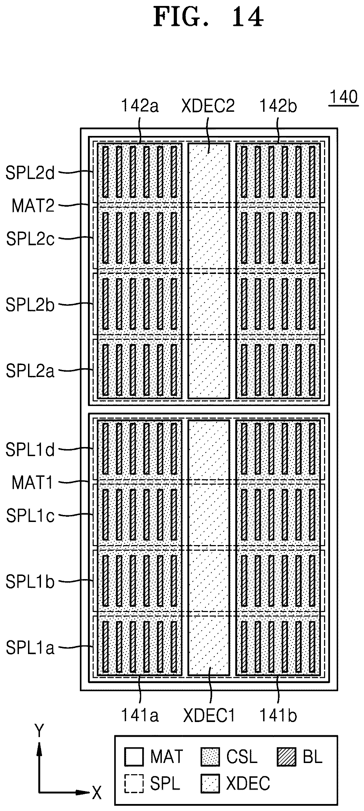

FIG. 14 is a plan view illustrating a memory device, according to an embodiment.

Referring to FIG. 14, the memory device 140 may include a plurality of MATs (e.g., a first MAT MAT1 and a second MAT MAT2) arranged in the first direction Y. In such a manner, the plurality of MATs MAT1 and MAT2 may be arranged in a 2×1 array form. For example, each of the plurality of MATs MAT1 and MAT2 may include and/or may be similar in many respects to the memory cell array 11 of FIGS. 1 or 10. The memory device 140 may include and/or may be similar in many respects to a modified example of the memory device 130 of FIG. 13, and the description given above with reference to FIG. 13 may also be applied to the memory device 140.

In an embodiment, each of the plurality of MATs MAT1 and MAT2 may include four (4) sub-planes. For example, the first MAT MAT1 may include a plurality of sub-planes (e.g., a first sub-plane SPL1a, a second sub-plane SPL1b, a third sub-plane SPL1c, and a fourth sub-plane SPL1d), bit lines BL respectively connected to the plurality of sub-planes SPL1a to SPL1d, and a plurality of common source plates (e.g., a first common source plate 141a and a second common source plate 141b). The memory device 140 may further include a row decoder XDEC1 connected to the first MAT MAT1. As another example, the second MAT MAT2 may include a plurality of sub-planes (e.g., a first sub-plane SPL2a, a second sub-plane SPL2b, a third sub-plane SPL2c, and a fourth sub-plane SPL2d), bit lines BL respectively connected to the plurality of sub-planes SPL2a to SPL2d, and a plurality of common source plates (e.g., a first common source plate 142a and a second common source plate 142b). The memory device 140 may further include a row decoder XDEC2 connected to the second MAT MAT2.

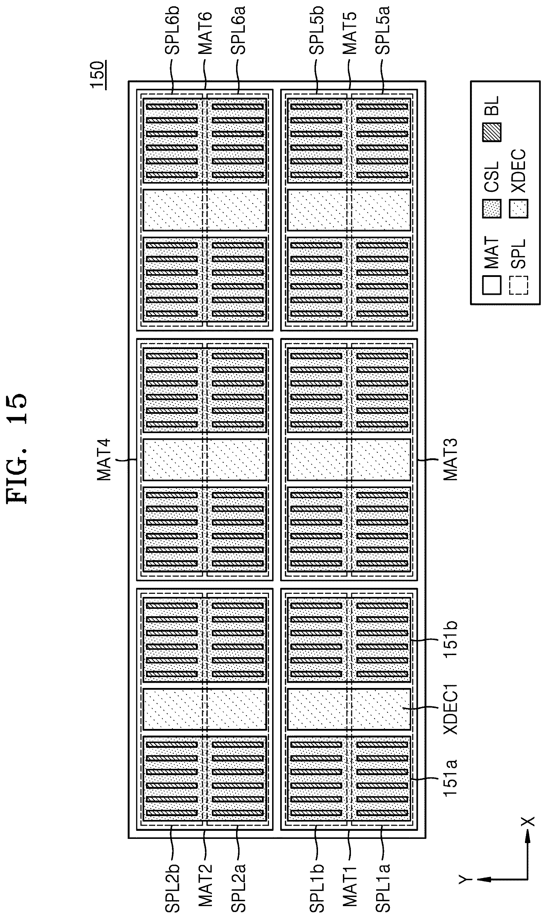

FIG. 15 is a plan view illustrating a memory device, according to an embodiment.

Referring to FIG. 15, a memory device 150 may include a plurality of MATs. For example, the memory device 150 may include a first MAT MAT1 and a second MAT MAT2 arranged in the first direction Y, a third MAT MAT3 and a fourth MAT MAT4 arranged in the first direction Y, and a fifth MAT MAT5 and a sixth MAT MAT6 arranged in the first direction Y. In an embodiment, the first, third, and fifth MATs MAT1, MAT3, and MAT5 may be arranged in the second direction X, and the second, fourth, and sixth MATs MAT2, MAT4, and MAT6 may be arranged in the second direction X. In such a manner, the plurality of MATs MAT1 to MAT6 may be arranged in a 2×3 array form. For example, each of the plurality of MATs MAT1 to MAT6 may include and/or may be similar in many respects to the memory cell array 11 of FIGS. 1 or 10.

The memory device 150 may include and/or may be similar in many respects to a modified example of the memory device 50 of FIG. 5, and the description given above with reference to FIG. 5 may also be applied to the memory device 150. In an embodiment, each of the plurality MATs MAT1 to MAT6 may include two (2) sub-planes. For example, the first MAT MAT1 may include first and second sub-planes SPL1a and SPL1b, bit lines BL respectively connected to the first and second sub-planes SPL1a and SPL1b, and first and second common source plates 151a and 151b. The memory device 150 may further include a row decoder XDEC1 connected to the first MAT MAT1.

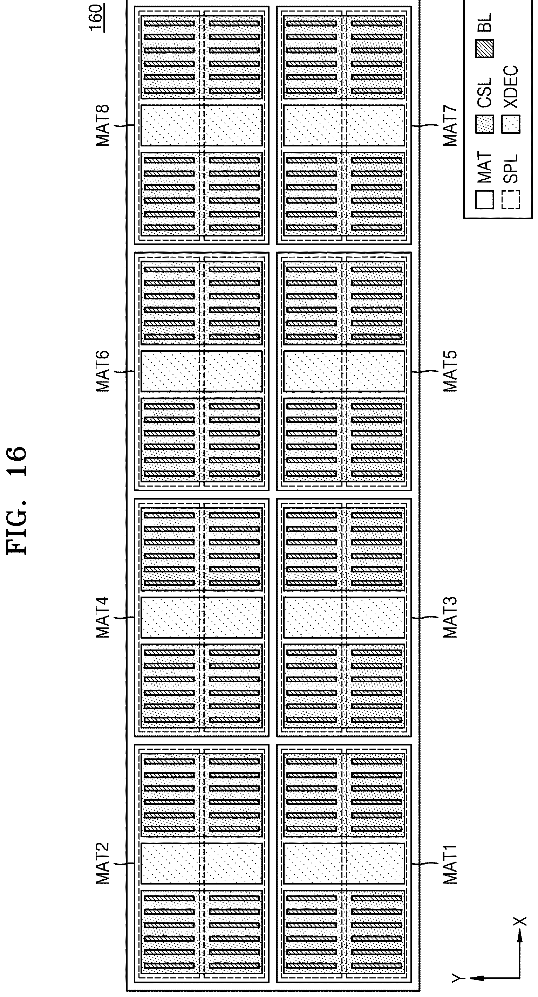

FIG. 16 is a plan view illustrating a memory device, according to an embodiment.

Referring to FIG. 16, a memory device 160 may include a plurality of MATs. For example, the memory device 160 may include a first MAT MAT1 and a second MAT MAT2 arranged in the first direction Y, a third MAT MAT3 and a fourth MAT MAT4 arranged in the first direction Y, a fifth MAT MAT5 and a sixth MAT MAT6 arranged in the first direction Y, and a seventh MAT MAT7 and an eighth MAT MAT8 arranged in the first direction Y. In an embodiment, the first, third, fifth, and seventh MATs MAT1, MAT3, MAT5, and MAT7 may be arranged in the second direction X, and the second, fourth, sixth, and eighth MATs MAT2, MAT4, MAT6, and MAT8 may be arranged in the second direction X. In such a manner, the plurality of MATs MATI1 to MAT8 may be arranged in a 2×4 array form. For example, each of the plurality of MATs MAT1 to MAT8 may include and/or may be similar in many respects to the memory cell array 11 of FIGS. 1 or 10. The memory device 160 may include and/or may be similar in many respects to a modified example of the memory device 150 of FIG. 15, and the description given above with reference to FIG. 15 may also be applied to the present embodiment. In an embodiment, each of the first to eighth MATs MAT1 to MAT8 may include two (2) sub-planes and two (2) common source plates.

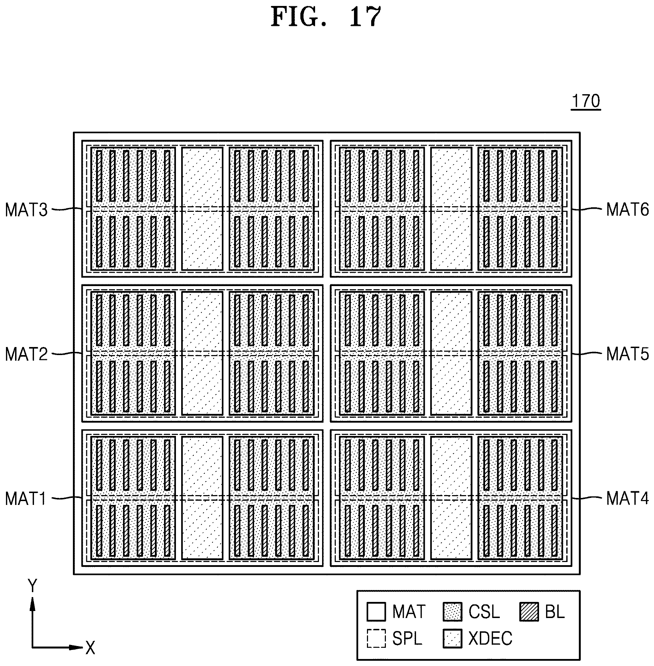

FIG. 17 is a plan view illustrating a memory device, according to an embodiment.

Referring to FIG. 17, a memory device 170 may include a plurality of MATs. For example, the memory device 170 may include a first MAT MAT1, a second MAT MAT2, and a third MAT MAT3 arranged in the first direction Y and a fourth MAT MAT4, a fifth MAT MAT5, and a sixth MAT MAT6 arranged in the first direction Y. In an embodiment, the first and fourth MATs MAT1 and MAT4 may be adjacent in the second direction X, the second and fifth MATs MAT2 and MAT5 may be adjacent in the second direction X, and the third and sixth MATs MAT3 and MAT6 may be adjacent in the second direction X. In such a manner, the plurality of MATs MATI1 to MAT6 may be arranged in a 3×2 array form. For example, each of the plurality of MATs MAT1 to MAT6 may include and/or may be similar in many respects to the memory cell array 11 of FIGS. 1 or 10. The memory device 170 may include and/or may be similar in many respects to a modified example of the memory device 50 of FIG. 5, and the description given above with reference to FIG. 5 may also be applied to the memory device 170. In an embodiment, each of the plurality of MATs MAT1 to MAT6 may include two (2) sub-planes and two (2) common source plates.

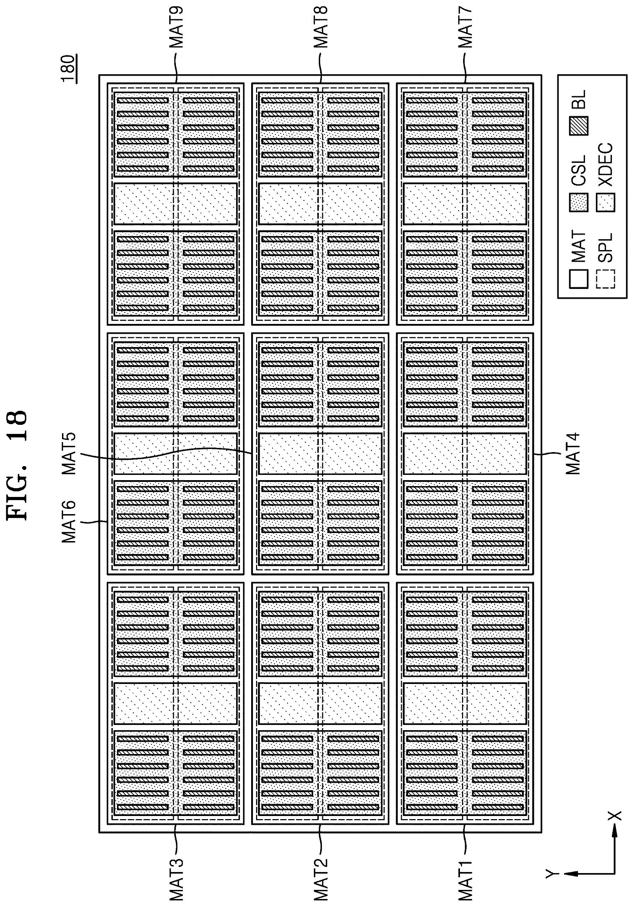

FIG. 18 is a plan view illustrating a memory device, according to an embodiment.

Referring to FIG. 18, a memory device 180 may include a plurality of MATs. For example, the memory device 180 may include a first MAT MAT1, a second MAT MAT2, and a third MAT MAT3 arranged in the first direction Y, a fourth MAT MAT4, a fifth MAT MAT5, and a sixth MAT MAT6 arranged in the first direction Y, and a seventh MAT MAT7, an eighth MAT MAT8, and a ninth MAT MAT9 arranged in the first direction Y. In an embodiment, the first, fourth, and seventh MATs MAT1, MAT4, and MAT7 may be adjacent in the second direction X, the second, fifth, and eighth MATs MAT2, MAT5, and MAT8 may be adjacent in the second direction X, and the third, sixth, and ninth MATs MAT3, MAT6, and MAT9 may be adjacent in the second direction X. In such a manner, the plurality of MATs MAT1 to MAT9 may be arranged in a 3×3 array form. For example, each of the plurality of MATs MAT1 to MAT9 may include and/or may be similar in many respects to the memory cell array 11 of FIGS. 1 or 10. The memory device 180 may include and/or may be similar in many respects to a modified example of the memory device 170 of FIG. 17, and the description given above with reference to FIG. 17 may also be applied to the memory device 180. In an embodiment, each of the plurality of MATs MAT1 to MAT9 may include two (2) sub-planes and two (2) common source plates.

FIG. 19 is a cross-sectional view illustrating a memory device, according to an embodiment. In this embodiment, the memory device 500 has a B-VNAND structure.

Referring to FIG. 19, a memory device 500 may have a C2C structure. At least one upper chip including a cell region and a lower chip including a peripheral circuit region PERI may be manufactured separately, and then, the at least one upper chip and the lower chip may be connected to each other by a bonding method to realize the C2C structure. For example, the bonding method may refer to a method of electrically and/or physically connecting a bonding metal pattern formed in an uppermost metal layer of the upper chip to a bonding metal pattern formed in an uppermost metal layer of the lower chip. For example, in a case in which the bonding metal patterns are formed of copper (Cu), the bonding method may be a Cu-Cu bonding method. Alternatively, the bonding metal patterns may include, but not be limited to, aluminum (Al), tungsten (W), or the like.

The memory device 500 may include at least one upper chip including the cell region. For example, as illustrated in FIG. 19, the memory device 500 may include two (2) upper chips. However, embodiments of the present disclosure are not limited thereto, and the memory device 500 may include more (e.g., three (3) or more) upper chips. In a case in which the memory device 500 includes the two (2) upper chips, a first upper chip including a first cell region CELL1, a second upper chip including a second cell region CELL2 and the lower chip including the peripheral circuit region PERI may be manufactured separately, and then, the first upper chip, the second upper chip and the lower chip may be connected to each other by the bonding method to manufacture the memory device 500. The first upper chip may be turned over and then may be connected to the lower chip by the bonding method, and the second upper chip may also be turned over and then may be connected to the first upper chip by the bonding method. Hereinafter, the upper and lower portions of each of the first and second upper chips may be defined based on an orientation of the chips before each of the first and second upper chips is turned over. That is, an upper portion of the lower chip may refer to an upper portion defined based on a +Z-axis direction, and the upper portion of each of the first and second upper chips may refer to an upper portion defined based on a -Z-axis direction in FIG. 19. However, embodiments of the present disclosure are not limited thereto. In some embodiments, at least one of the first upper chip or the second upper chip may be turned over and then may be connected to a corresponding chip by the bonding method.

Each of the peripheral circuit region PERI and the first and second cell regions CELL1 and CELL2 of the memory device 500 may include an external pad bonding region PA, a word line bonding region WLBA, and a bit line bonding region BLBA.

The peripheral circuit region PERI may include a first substrate 210 and a plurality of circuit devices (e.g., a first circuit device 220a, a second circuit device 220b, and a third circuit device 220c) formed on the first substrate 210. An interlayer insulating layer 215 including one or more insulating layers may be provided on the plurality of circuit devices 220a to 220c, and a plurality of metal lines electrically connected to the plurality of circuit devices 220a to 220c may be provided in the interlayer insulating layer 215. For example, the plurality of metal lines may include first metal lines (e.g., a first metal line 230a, a second metal line 230b, and a third metal line 230c) connected to the plurality of circuit devices 220a to 220c, and second metal lines (e.g., a fourth metal line 240a, a fifth metal line 240b, and a sixth metal line 240c) formed on the first metal lines 230a to 230c. The plurality of metal lines may include at least one of various conductive materials. For example, the first metal lines 230a to 230c may include tungsten (W) having a relatively high electrical resistivity, and the second metal lines 240a to 240c may include copper (Cu) having a relatively low electrical resistivity.

The first metal lines 230a to 230c and the second metal lines 240a to 240c are illustrated and described based on the present embodiments. However, embodiments of the present disclosure are not limited thereto. In some embodiments, at least one or more additional metal lines may further be formed on the second metal lines 240a to 240c. In such a manner, the second metal lines 240a to 240c may include aluminum (Al), and at least some of the additional metal lines formed on the second metal lines 240a to 240c may include copper (Cu) having an electrical resistivity lower than that of aluminum (Al) of the second metal lines 240a to 240c.

The interlayer insulating layer 215 may be placed on the first substrate 210 and may include an insulating material, such as, but not limited to, silicon oxide (SiO) and/or silicon nitride (SiN).

Each of the first and second cell regions CELL1 and CELL2 may include at least one memory block. The first cell region CELL1 may include a second substrate 310 and a common source line 320. A plurality of word lines 330 (e.g., a first word line 331, a second word line 332, a third word line 333, a fourth word line 334, a fifth word line 335, a sixth word line 336, a seventh word line 337, and an eighth word line 338) may be stacked on the second substrate 310 in a direction (e.g., the Z-axis direction) perpendicular to a top surface of the second substrate 310. In some embodiments, the plurality of word lines 330 may be formed in at least one memory block. String selection lines and a ground selection line may be placed on and under the word lines 330, and the plurality of word lines 330 may be placed between the string selection lines and the ground selection line. Likewise, the second cell region CELL2 may include a third substrate 410 and a common source line 420, and a plurality of word lines 430 (e.g., a first word line 431, a second word line 432, a third word line 433, a fourth word line 434, a fifth word line 435, a sixth word line 436, a seventh word line 437, and an eighth word line 438) may be stacked on the third substrate 410 in a direction (e.g., the Z-axis direction) perpendicular to a top surface of the third substrate 410. In some embodiments, the plurality of word lines 430 may be formed in at least one memory block. Each of the second substrate 310 and the third substrate 410 may include at least one of various materials, such as, but not limited to, a silicon (Si) substrate, a silicon-germanium (Si-Ge) substrate, a germanium (Ge) substrate, or a substrate having a single-crystalline epitaxial layer grown on a single-crystalline silicon substrate. A plurality of channel structures CH may be formed in each of the first and second cell regions CELL1 and CELL2. In some embodiments, the plurality of channel structures CH may be formed in at least one memory block.

In some embodiments, as illustrated in a region A (e.g., region A1), the channel structure CH may be provided in the bit line bonding region BLBA and may extend in the direction perpendicular to the top surface of the second substrate 310 to penetrate the word lines 330, the string selection lines, and the ground selection line. The channel structure CH may include a data storage layer, a channel layer, and a filling insulation layer. The channel layer may be electrically connected to a first metal line 350c and a second metal line 360c in the bit line bonding region BLBA. For example, the second metal line 360c may be a bit line and may be connected to the channel structure CH through the first metal line 350c. The bit line 360c may extend in the first direction (e.g., a Y-axis direction) parallel to the top surface of the second substrate 310.

In some embodiments, as illustrated in a the region A (e.g., region A2), the channel structure CH may include a lower channel LCH and an upper channel UCH, which may be connected to each other. For example, the channel structure CH may be formed by a process of forming the lower channel LCH and/or a process of forming the upper channel UCH. The lower channel LCH may extend in the direction perpendicular to the top surface of the second substrate 310 to penetrate the common source line 320 and lower word lines 331 and 332. The lower channel LCH may include a data storage layer, a channel layer, and a filling insulation layer and may be connected to the upper channel UCH. The upper channel UCH may penetrate upper word lines 333 to 338. The upper channel UCH may include a data storage layer, a channel layer, and a filling insulation layer, and the channel layer of the upper channel UCH may be electrically connected to the first metal line 350c and the second metal line 360c. As a length of a channel increases, due to characteristics of manufacturing processes, it may be difficult to form a channel having a substantially uniform width. The memory device 500, according to an embodiment, may include a channel having improved width uniformity due to the lower channel LCH and the upper channel UCH, which may be formed by the processes performed sequentially, when compared to related nonvolatile memory device.

In a case in which the channel structure CH includes the lower channel LCH and the upper channel UCH, as illustrated in the region A2, a word line located near to a boundary between the lower channel LCH and the upper channel UCH may be a dummy word line. For example, the second and third word lines 332 and 333 adjacent to the boundary between the lower channel LCH and the upper channel UCH may be the dummy word lines. In such a case, data may not be stored in memory cells connected to the dummy word line. Alternatively or additionally, the number of pages corresponding to the memory cells connected to the dummy word line may be less than the number of pages corresponding to the memory cells connected to a general word line. A level of a voltage applied to the dummy word line may be different from a level of a voltage applied to the general word line, and thus it is possible to reduce an influence of a non-uniform channel width between the lower and upper channels LCH and UCH on an operation of the memory device.

In addition, the number of lower word lines (e.g., the first and second word lines 331 and 332) penetrated by the lower channel LCH may be less than the number of upper word lines (e.g., the third to eighth word lines 333 to 338) penetrated by the upper channel UCH in the region A2. However, embodiments of the present disclosure are not limited thereto. In some embodiments, the number of lower word lines penetrated by the lower channel LCH may be equal to or more than the number of upper word lines penetrated by the upper channel UCH. In addition, structural features and connection relations of the channel structure CH placed in the second cell region CELL2 may be substantially the same as those of the channel structure CH placed in the first cell region CELL1.

In the bit line bonding region BLBA, a first through-electrode THV1 may be provided in the first cell region CELL1, and a second through-electrode THV2 may be provided in the second cell region CELL2. As illustrated in FIG. 19, the first through-electrode THV1 may penetrate the common source line 320 and the plurality of word lines 330. In certain embodiments, the first through-electrode THV1 may further penetrate the second substrate 310. The first through-electrode THV1 may include a conductive material. Alternatively, the first through-electrode THV1 may include a conductive material surrounded by an insulating material. The second through-electrode THV2 may have the same shape and structure as the first through-electrode THV1.

In some embodiments, the first through-electrode THV1 and the second through-electrode THV2 may be electrically connected to each other through a first through-metal pattern 372d and a second through-metal pattern 472d. The first through-metal pattern 372d may be formed at a bottom end of the first upper chip including the first cell region CELL1, and the second through-metal pattern 472d may be formed at a top end of the second upper chip including the second cell region CELL2. The first through-electrode THV1 may be electrically connected to the first metal line 350c and the second metal line 360c. A lower via 371d may be formed between the first through-electrode THV1 and the first through-metal pattern 372d, and an upper via 471d may be formed between the second through-electrode THV2 and the second through-metal pattern 472d. The first through-metal pattern 372d and the second through-metal pattern 472d may be connected to each other by the bonding method.

In addition, in the bit line bonding region BLBA, an upper metal pattern 252 may be formed in an uppermost metal layer of the peripheral circuit region PERI, and an upper metal pattern 392 having the same shape as the upper metal pattern 252 may be formed in an uppermost metal layer of the first cell region CELL1. The upper metal pattern 392 of the first cell region CELL1 and the upper metal pattern 252 of the peripheral circuit region PERI may be electrically connected to each other by the bonding method. In the bit line bonding region BLBA, the bit line 360c may be electrically connected to a page buffer included in the peripheral circuit region PERI. For example, some of the circuit devices 220c of the peripheral circuit region PERI may constitute the page buffer, and the bit line 360c may be electrically connected to the circuit devices 220c constituting the page buffer through an upper bonding metal pattern 370c of the first cell region CELL1 and an upper bonding metal pattern 270c of the peripheral circuit region PERI.

Continuing to refer to FIG. 19, in the word line bonding region WLBA, the word lines 330 of the first cell region CELL1 may extend in the second direction (e.g., an X-axis direction) parallel to the top surface of the second substrate 310 and may be connected to a plurality of cell contact plugs 340 (e.g., a first cell contact plug 341, a second cell contact plug 342, a third cell contact plug 343, a fourth cell contact plug 344, a fifth cell contact plug 345, a sixth cell contact plug 346, and a seventh cell contact plug 347). First metal lines 350b and second metal lines 360b may be sequentially connected onto the cell contact plugs 340 connected to the word lines 330. In the word line bonding region WLBA, the cell contact plugs 340 may be connected to the peripheral circuit region PERI through upper bonding metal patterns 370b of the first cell region CELL1 and upper bonding metal patterns 270b of the peripheral circuit region PERI.

The cell contact plugs 340 may be electrically connected to a row decoder included in the peripheral circuit region PERI. For example, some of the circuit devices 220b of the peripheral circuit region PERI may constitute the row decoder, and the cell contact plugs 340 may be electrically connected to the circuit devices 220b constituting the row decoder through the upper bonding metal patterns 370b of the first cell region CELL1 and the upper bonding metal patterns 270b of the peripheral circuit region PERI. In some embodiments, an operating voltage of the circuit devices 220b constituting the row decoder may be different from an operating voltage of the circuit devices 220c constituting the page buffer. For example, the operating voltage of the circuit devices 220c constituting the page buffer may be greater than the operating voltage of the circuit devices 220b constituting the row decoder.

Similarly, in the word line bonding region WLBA, the word lines 430 of the second cell region CELL2 may extend in the second direction (e.g., the X-axis direction) parallel to the top surface of the third substrate 410 and may be connected to a plurality of cell contact plugs 440 (e.g., a first cell contact plug 441, a second cell contact plug 442, a third cell contact plug 443, a fourth cell contact plug 444, a fifth cell contact plug 445, a sixth cell contact plug 446, and a seventh cell contact plug 447). The cell contact plugs 440 may be connected to the peripheral circuit region PERI through an upper metal pattern of the second cell region CELL2 and lower and upper metal patterns and a cell contact plug 348 of the first cell region CELL1.

In the word line bonding region WLBA, the upper bonding metal patterns 370b may be formed in the first cell region CELL1, and the upper bonding metal patterns 270b may be formed in the peripheral circuit region PERI. The upper bonding metal patterns 370b of the first cell region CELL1 and the upper bonding metal patterns 270b of the peripheral circuit region PERI may be electrically connected to each other by the bonding method. The upper bonding metal patterns 370b and the upper bonding metal patterns 270b may include aluminum, copper, or tungsten.

In the external pad bonding region PA, a lower metal pattern 371e may be formed in a lower portion of the first cell region CELL1, and an upper metal pattern 472a may be formed in an upper portion of the second cell region CELL2. The lower metal pattern 371e of the first cell region CELL1 and the upper metal pattern 472a of the second cell region CELL2 may be connected to each other by the bonding method in the external pad bonding region PA. Similarly, an upper metal pattern 372a may be formed in an upper portion of the first cell region CELL1, and an upper metal pattern 272a may be formed in an upper portion of the peripheral circuit region PERI. The upper metal pattern 372a of the first cell region CELL1 and the upper metal pattern 272a of the peripheral circuit region PERI may be connected to each other by the bonding method.

Common source line contact plugs 380 and 480 may be placed in the external pad bonding region PA. The common source line contact plugs 380 and 480 may include a conductive material, such as, but not limited to, a metal, a metal compound, and/or doped polysilicon. The common source line contact plug 380 of the first cell region CELL1 may be electrically connected to the common source line 320, and the common source line contact plug 480 of the second cell region CELL2 may be electrically connected to the common source line 420. A first metal line 350a and a second metal line 360a may be sequentially stacked on the common source line contact plug 380 of the first cell region CELL1, and a first metal line 450a and a second metal line 460a may be sequentially stacked on the common source line contact plug 480 of the second cell region CELL2.

A plurality of I/O pads (e.g., a first I/O pad 205, a second I/O pad 405, and a third I/O pad 406) may be placed in the external pad bonding region PA. Referring to FIG. 19, a lower insulating layer 201 may cover a bottom surface of the first substrate 210, and the first I/O pad 205 may be formed on the lower insulating layer 201. The first I/O pad 205 may be connected to at least one of a plurality of the circuit devices 220a placed in the peripheral circuit region PERI through a first I/O contact plug 203 and may be separated from the first substrate 210 by the lower insulating layer 201. In addition, a side insulating layer may be placed between the first I/O contact plug 203 and the first substrate 210 to electrically isolate the first I/O contact plug 203 from the first substrate 210.

An upper insulating layer 401 covering a top surface of the third substrate 410 may be formed on the third substrate 410. The second I/O pad 405 and/or the third I/O pad 406 may be placed on the upper insulating layer 401. The second I/O pad 405 may be connected to at least one of the plurality of circuit devices 220a placed in the peripheral circuit region PERI through second I/O contact plugs 403 and 303, and the third I/O pad 406 may be connected to at least one of the plurality of circuit devices 220a placed in the peripheral circuit region PERI through third I/O contact plugs 404 and 304.

In some embodiments, the third substrate 410 may not be placed in a region in which the I/O contact plug is disposed. For example, as illustrated in a region B, the third I/O contact plug 404 may be separated from the third substrate 410 in a direction parallel to the top surface of the third substrate 410 and may penetrate an interlayer insulating layer 415 of the second cell region CELL2 so as to be connected to the third I/O pad 406. In such a case, the third I/O contact plug 404 may be formed by at least one of various processes.

In some embodiments, as illustrated in a region B1, the third I/O contact plug 404 may extend in a third direction (e.g., the Z-axis direction), and a diameter of the third I/O contact plug 404 may become progressively greater (more) toward the upper insulating layer 401. That is, a diameter of the channel structure CH described in the region A1 may become progressively smaller (less) toward the upper insulating layer 401, but the diameter of the third I/O contact plug 404 may become progressively greater toward the upper insulating layer 401. For example, the third I/O contact plug 404 may be formed after the second cell region CELL2 and the first cell region CELL1 are bonded to each other by the bonding method.

In certain embodiments, as illustrated in a region B2, the third I/O contact plug 404 may extend in the third direction (e.g., the Z-axis direction), and a diameter of the third I/O contact plug 404 may become progressively smaller toward the upper insulating layer 401. That is, similar to the channel structure CH, the diameter of the third I/O contact plug 404 may become progressively smaller toward the upper insulating layer 401. For example, the third I/O contact plug 404 may be formed together with the cell contact plugs 440 before the second cell region CELL2 and the first cell region CELL1 are bonded to each other.

In some embodiments, the I/O contact plug may overlap with the third substrate 410. For example, as illustrated in a region C, the second I/O contact plug 403 may penetrate the interlayer insulating layer 415 of the second cell region CELL2 in the third direction (e.g., the Z-axis direction) and may be electrically connected to the second I/O pad 405 through the third substrate 410. In such a case, a connection structure of the second I/O contact plug 403 and the second I/O pad 405 may be realized by various methods.

In some embodiments, as illustrated in a region C1, an opening 408 may be formed to penetrate the third substrate 410, and the second I/O contact plug 403 may be connected directly to the second I/O pad 405 through the opening 408 formed in the third substrate 410. In such a case, as illustrated in the region C1, a diameter of the second I/O contact plug 403 may become progressively greater toward the second I/O pad 405. However, embodiments of the present disclosure are not limited thereto, and in some embodiments, the diameter of the second I/O contact plug 403 may become progressively smaller toward the second I/O pad 405.

In some embodiments, as illustrated in a region C2, the opening 408 penetrating the third substrate 410 may be formed, and a contact 407 may be formed in the opening 408. An end of the contact 407 may be connected to the second I/O pad 405, and another end of the contact 407 may be connected to the second I/O contact plug 403. Thus, the second I/O contact plug 403 may be electrically connected to the second I/O pad 405 through the contact 407 in the opening 408. In such a case, as illustrated in the region C2, a diameter of the contact 407 may become progressively greater toward the second I/O pad 405, and a diameter of the second I/O contact plug 403 may become progressively smaller toward the second I/O pad 405. For example, the second I/O contact plug 403 may be formed together with the cell contact plugs 440 before the second cell region CELL2 and the first cell region CELL1 are bonded to each other, and the contact 407 may be formed after the second cell region CELL2 and the first cell region CELL1 are bonded to each other.

In some embodiments, as illustrated in a region C3, a stopper 409 may further be formed on a bottom end of the opening 408 of the third substrate 410, as compared with the embodiments of the region C2. The stopper 409 may be a metal line formed in the same layer as the common source line 420. Alternatively, the stopper 409 may be a metal line formed in the same layer as at least one of the word lines 430. The second I/O contact plug 403 may be electrically connected to the second I/O pad 405 through the contact 407 and the stopper 409.

Similar to the second and third I/O contact plugs 403 and 404 of the second cell region CELL2, a diameter of each of the second and third I/O contact plugs 303 and 304 of the first cell region CELL1 may become progressively smaller toward the lower metal pattern 371e and/or may become progressively greater toward the lower metal pattern 371e.

In some embodiments, a slit 411 may be formed in the third substrate 410. For example, the slit 411 may be formed at a certain position of the external pad bonding region PA. For example, as illustrated in a region D, the slit 411 may be located between the second I/O pad 405 and the cell contact plugs 440 when viewed in a plan view. Alternatively, the second I/O pad 405 may be located between the slit 411 and the cell contact plugs 440 when viewed in a plan view.

In some embodiments, as illustrated in a region D1, the slit 411 may be formed to penetrate the third substrate 410. For example, the slit 411 may be used to prevent the third substrate 410 from being finely cracked when the opening 408 is formed. However, embodiments are not limited thereto, and in some embodiments, the slit 411 may be formed to have a depth ranging from about 60% to about 70% of a thickness of the third substrate 410.

In some embodiments, as illustrated in a region D2, a conductive material 412 may be formed in the slit 411. For example, the conductive material 412 may be used to discharge a leakage current occurring in driving of the circuit devices in the external pad bonding region PA to the outside. In such a case, the conductive material 412 may be connected to an external ground line.

In some embodiments, as illustrated in a region D3, an insulating material 413 may be formed in the slit 411. For example, the insulating material 413 may be used to electrically isolate the second I/O pad 405 and the second I/O contact plug 403 placed in the external pad bonding region PA from the word line bonding region WLBA. Since the insulating material 413 is formed in the slit 411, it may be possible to prevent and/or reduce a voltage provided through the second I/O pad 405 from affecting a metal layer placed on the third substrate 410 in the word line bonding region WLBA, when compared to related nonvolatile memory devices.

In some embodiments, the first to third I/O pads 205, 405, and 406 may be selectively formed. For example, the memory device 500 may be realized to include only the first I/O pad 205 placed on the first substrate 210, to include only the second I/O pad 405 placed on the third substrate 410, or to include only the third I/O pad 406 placed on the upper insulating layer 401.

In some embodiments, at least one of the second substrate 310 of the first cell region CELL1 or the third substrate 410 of the second cell region CELL2 may be used as a sacrificial substrate and may be completely or partially removed before or after a bonding process. An additional layer may be stacked after the removal of the substrate. For example, the second substrate 310 of the first cell region CELL1 may be removed before or after the bonding process of the peripheral circuit region PERI and the first cell region CELL1, and then, an insulating layer covering a top surface of the common source line 320 or a conductive layer for connection may be formed. Similarly, the third substrate 410 of the second cell region CELL2 may be removed before or after the bonding process of the first cell region CELL1 and the second cell region CELL2, and, the upper insulating layer 401 covering a top surface of the common source line 420 and/or a conductive layer for connection may be formed.

According to embodiments, a memory cell array included in each of the first and second cell regions CELL1 and CELL2 of the memory device 500 may be divided into a plurality of sub-planes, and the plurality of sub-planes may be arranged in an extension direction of a bit line (e.g., the first direction Y). The arrangement of the sub-planes may reduce the size of each of the first and second cell regions CELL1 and CELL2 including memory cell arrays. In addition, the arrangement of these sub-planes may improve the aspect ratio of a chip including the memory device 500, thereby increasing the utilization efficiency of wafers, when compared to related nonvolatile memory devices.

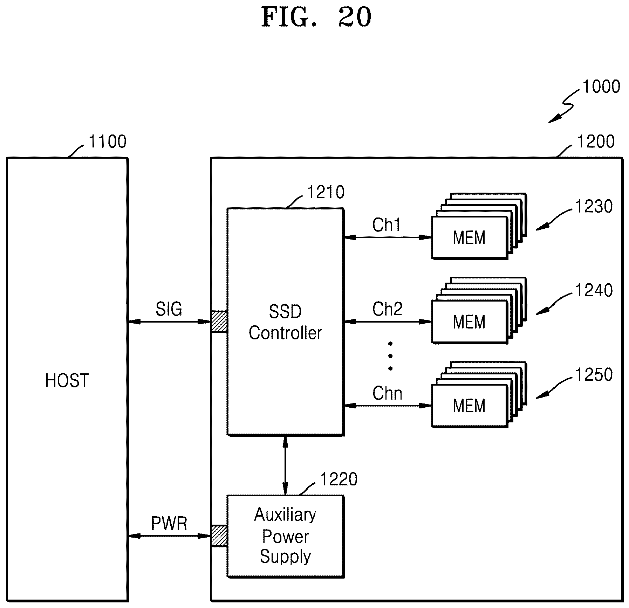

FIG. 20 illustrates a solid state drive (SSD) system including a memory device, according to an embodiment.

Referring to FIG. 20, an SSD system 1000 may include a host 1100 and an SSD 1200. The SSD 1200 may exchange signals (SIG) with the host 1100 through a signal connector and/or may receive power (PWR) through a power connector. The SSD 1200 may include an SSD controller 1210, an auxiliary power supply 1220, and a plurality of memory devices (MEM) (e.g., a first memory device 1230, a second memory device 1240, and a third memory device 1250). The plurality of memory devices 1230 to 1250 may be and/or may include vertically-stacked NAND flash memory devices. In some embodiments, the plurality of memory devices 1230 to 1250 may be connected to the SSD controller 1210 through a plurality of channels Ch1 to Chn, respectively. The SSD 1200 may be implemented using one or more embodiments described above with reference to FIGS. 1 to 19.

While the present disclosure has been particularly shown and described with reference to embodiments thereof, it is to be understood that various changes in form and details may be made therein without departing from the scope of the following claims.

Embodiments are set out in the following clauses:
Clause 1: A nonvolatile memory device, comprising:
   a memory cell region comprising a plurality of memory cell arrays arranged in a first direction, each of the plurality of memory cell arrays comprising a plurality of sub-planes arranged in the first direction, each of the plurality of sub-planes extending in a second direction intersecting the first direction; and
   a peripheral circuit region disposed below the memory cell region in a vertical direction, the peripheral circuit region comprising a plurality of page buffer circuits respectively coupled with the plurality of memory cell arrays,
   wherein each of the plurality of memory cell arrays further comprises:
      a first common source plate extending in the first direction and commonly coupled with the plurality of sub-planes;
      a first bit line group coupled with a first sub-plane from among the plurality of sub-planes; and
      a second bit line group coupled with a second sub-plane from among the plurality of sub-planes,
   wherein each of the plurality of page buffer circuits comprises:
      first page buffers coupled with the first sub-plane through the first bit line group; and
      second page buffers coupled with the second sub-plane through the second bit line group.
Clause 2: The nonvolatile memory device of clause 1, wherein each of the plurality of sub-planes comprises a plurality of memory blocks, and
   wherein each of the plurality of memory blocks comprises:
   a channel structure extending in the vertical direction; and
   a plurality of word lines coupled with the channel structure.
Clause 3: The nonvolatile memory device of clause 1, wherein each of the plurality of sub-planes comprises a plurality of memory blocks, and
   wherein each of the plurality of memory blocks comprises:
   a plurality of memory stacks stacked in the vertical direction, each of the plurality of memory stacks extending in the vertical direction; and
   a plurality of word lines coupled with the plurality of memory stacks.
Clause 4: The nonvolatile memory device of any preceding clause, wherein each of the plurality of memory cell arrays further comprises a second common source plate extending in the first direction and apart from the first common source plate in the second direction,
   wherein the first sub-plane comprises first memory blocks coupled with the first common source plate and second memory blocks coupled with the second common source plate, and
   wherein the second sub-plane comprises third memory blocks coupled with the first common source plate and fourth memory blocks coupled with the second common source plate.
Clause 5: The nonvolatile memory device of clause 4, wherein each of the plurality of memory cell arrays further comprises:
   a first word line group commonly coupled with the first memory blocks and the second memory blocks; and
   a second word line group commonly coupled with the third memory blocks and the fourth memory blocks.
Clause 6: The nonvolatile memory device of clause 4, wherein each of the plurality of memory cell arrays further comprises:
   a first word line group coupled with the first memory blocks;
   a second word line group coupled with the second memory blocks;
   a third word line group coupled with the third memory blocks; and
   a fourth word line group coupled with the fourth memory blocks.
Clause 7: The nonvolatile memory device of any of clauses 4 to 6, wherein the peripheral circuit region further comprises:
   a first row decoder disposed under a first region between the first memory blocks and the second memory blocks; and
   a second row decoder disposed under a second region between the third memory blocks and the fourth memory blocks.
Clause 8: The nonvolatile memory device of any of clauses 1 to 6, wherein the peripheral circuit region further comprises:
   a first row decoder coupled with the first sub-plane; and
   a second row decoder coupled with the second sub-plane.
Clause 9: The nonvolatile memory device of clause 8, wherein the peripheral circuit region further comprises:
   a first pass transistor circuit coupled between the first row decoder and the first sub-plane; and
   a second pass transistor circuit coupled between the second row decoder and the second sub-plane (11b).
Clause 10: The nonvolatile memory device of any preceding clause, wherein the memory cell region further comprises upper bonding pads,
   wherein the peripheral circuit region further comprises lower bonding pads, and
   wherein the memory cell region is coupled with the peripheral circuit region in the vertical direction by the upper bonding pads and the lower bonding pads.
Clause 11: A nonvolatile memory device, comprising:
   a memory cell region comprising a plurality of memory cell arrays and upper bonding pads, the plurality of memory cell arrays comprising a first memory cell array, a second memory cell array, a third memory cell array, and a fourth memory cell array, the first memory cell array and the second memory cell array being disposed in a first direction, the third memory cell array and the fourth memory cell array being disposed in the first direction, the first memory cell array and the third memory cell array being disposed apart from each other in a second direction intersecting the first direction, the second memory cell array and the fourth memory cell array being disposed apart from each other in the second direction; and
   a peripheral circuit region comprising a plurality of page buffer circuits and lower bonding pads, the plurality of page buffer circuits comprising a first page buffer circuit, a second page buffer circuit, a third page buffer circuit, and a fourth page buffer circuit, the plurality of page buffer circuits being respectively coupled with the plurality of memory cell arrays,
   wherein the peripheral circuit region is coupled with the memory cell region by the upper bonding pads and the lower bonding pads in a vertical direction,
   wherein each of the plurality of memory cell arrays comprises a plurality of sub-planes arranged in the first direction, each of the plurality of sub-planes extending in the second direction, and the plurality of sub-planes being respectively coupled with a plurality of different bit line groups, and
   wherein each of the plurality of page buffer circuits comprises a plurality of page buffers respectively coupled with the plurality of sub-planes.
Clause 12: The nonvolatile memory device of clause 11, wherein each of the plurality of sub-planes comprises a plurality of memory blocks, and
   wherein each of the plurality of memory blocks comprises:
   a channel structure extending in the vertical direction; and
   a plurality of word lines coupled with the channel structure.
Clause 13: The nonvolatile memory device of clause 11, wherein each of the plurality of sub-planes comprises a plurality of memory blocks, and
   wherein each of the plurality of memory blocks comprises:
   a plurality of memory stacks stacked in the vertical direction, each of the plurality of memory stacks extending in the vertical direction; and
   a plurality of word lines coupled with the plurality of memory stacks.
Clause 14: The nonvolatile memory device of clause 11, wherein each of the plurality of memory cell arrays further comprises a first common source plate extending in the first direction and a second common source plate extending in the first direction, the first common source plate and the second common source plate being disposed apart from each other in the second direction,
   wherein each of the plurality of sub-planes comprises first memory blocks coupled with the first common source plate and second memory blocks coupled with the second common source plate, and
   wherein the peripheral circuit region comprises a row decoder disposed under a region between the first common source plate and the second common source plate.
Clause 15: The nonvolatile memory device of clause 14, wherein each of the plurality of memory cell arrays further comprises a first word line group commonly coupled with the first memory blocks and the second memory blocks.

## Claims

1. A nonvolatile memory device (10, 50), comprising:
a memory cell region (CELL) comprising a plurality of memory cell arrays (11) arranged in a first direction, each of the plurality of memory cell arrays (11) comprising a plurality of sub-planes (SPL1a-b, 11a-b) arranged in the first direction, each of the plurality of sub-planes (SPL1a-b, 11a-b) extending in a second direction intersecting the first direction; and
a peripheral circuit region (PERI) disposed below the memory cell region (CELL) in a vertical direction, the peripheral circuit region (PERI) comprising a plurality of page buffer circuits (12) respectively coupled with the plurality of memory cell arrays (11),
wherein each of the plurality of memory cell arrays (11) further comprises:
a first common source plate (51a) extending in the first direction and commonly coupled with the plurality of sub-planes (SPL1a-b, 11a-b);
a first bit line group (BLG1) coupled with a first sub-plane (SPL1a, 11a) from among the plurality of sub-planes (SPL1a-b, 11a-b); and
a second bit line group (BLG2) coupled with a second sub-plane (SPL1b, 11b) from among the plurality of sub-planes (SPL1a-b, 11a-b),
wherein each of the plurality of page buffer circuits (12) comprises:
first page buffers (12a) coupled with the first sub-plane (SPL1a, 11a) through the first bit line group (BLG1); and
second page buffers (12b) coupled with the second sub-plane (SPL1b, 11b) through the second bit line group (BLG2).

2. The nonvolatile memory device (10, 50) of claim 1, wherein each of the plurality of sub-planes (SPL1a-b, 11a-b) comprises a plurality of memory blocks (BLK), and
wherein each of the plurality of memory blocks (BLK) comprises:
a channel structure (CH) extending in the vertical direction; and
a plurality of word lines (WL) coupled with the channel structure (CH).

3. The nonvolatile memory device (10, 50) of claim 1, wherein each of the plurality of sub-planes (SPL1a-b, 11a-b) comprises a plurality of memory blocks (BLK), and
wherein each of the plurality of memory blocks (BLK) comprises:
a plurality of memory stacks stacked in the vertical direction, each of the plurality of memory stacks (CH_L, CH_U) extending in the vertical direction; and
a plurality of word lines (WL) coupled with the plurality of memory stacks.

4. The nonvolatile memory device (10, 50) of any preceding claim, wherein each of the plurality of memory cell arrays (11) further comprises a second common source plate (51b) extending in the first direction and apart from the first common source plate (51a) in the second direction,
wherein the first sub-plane (SPL1a, 11a) comprises first memory blocks coupled with the first common source plate (51a) and second memory blocks coupled with the second common source plate (51b), and
wherein the second sub-plane (SPL1b, 11b) comprises third memory blocks coupled with the first common source plate (51a) and fourth memory blocks coupled with the second common source plate (51b).

5. The nonvolatile memory device (10, 50) of claim 4, wherein each of the plurality of memory cell arrays (11) further comprises:
a first word line group commonly coupled with the first memory blocks and the second memory blocks; and
a second word line group commonly coupled with the third memory blocks and the fourth memory blocks.

6. The nonvolatile memory device (10, 50) of claim 4, wherein each of the plurality of memory cell arrays (11) further comprises:
a first word line group coupled with the first memory blocks;
a second word line group coupled with the second memory blocks;
a third word line group coupled with the third memory blocks; and
a fourth word line group coupled with the fourth memory blocks.

7. The nonvolatile memory device (10, 50) of any of claims 4 to 6, wherein the peripheral circuit region (PERI) further comprises:
a first row decoder disposed under a first region between the first memory blocks and the second memory blocks; and
a second row decoder disposed under a second region between the third memory blocks and the fourth memory blocks.

8. The nonvolatile memory device (100) of any of claims 1 to 6, wherein the peripheral circuit region (PERI) further comprises:
a first row decoder (15a) coupled with the first sub-plane (11a); and
a second row decoder (15b) coupled with the second sub-plane (11b).

9. The nonvolatile memory device (100) of claim 8, wherein the peripheral circuit region (PERI) further comprises:
a first pass transistor circuit coupled between the first row decoder (15a) and the first sub-plane (11a); and
a second pass transistor circuit coupled between the second row decoder (15b) and the second sub-plane (11b).

10. The nonvolatile memory device (50) of any preceding claim, wherein the memory cell region (CELL) further comprises upper bonding pads (UBP),
wherein the peripheral circuit region (PERI) further comprises lower bonding pads (LBP), and
wherein the memory cell region (CELL) is coupled with the peripheral circuit region (PERI) in the vertical direction by the upper bonding pads (UBP) and the lower bonding pads (LBP).

11. A nonvolatile memory device (40, 50), comprising:
a memory cell region (CELL) comprising a plurality of memory cell arrays and upper bonding pads (UBP), the plurality of memory cell arrays comprising a first memory cell array (MAT1), a second memory cell array (MAT2), a third memory cell array (MAT3), and a fourth memory cell array (MAT4), the first memory cell array (MAT1) and the second memory cell array (MAT2 )being disposed in a first direction (Y), the third memory cell array (MAT3) and the fourth memory cell array (MAT4) being disposed in the first direction (Y), the first memory cell array (MAT1) and the third memory cell array (MAT3) being disposed apart from each other in a second direction (X) intersecting the first direction (Y), the second memory cell array (MAT2) and the fourth memory cell array (MAT4) being disposed apart from each other in the second direction (X); and
a peripheral circuit region (PERI) comprising a plurality of page buffer circuits and lower bonding pads (LBP), the plurality of page buffer circuits comprising a first page buffer circuit, a second page buffer circuit, a third page buffer circuit, and a fourth page buffer circuit, the plurality of page buffer circuits being respectively coupled with the plurality of memory cell arrays,
wherein the peripheral circuit region (PERI) is coupled with the memory cell region (CELL) by the upper bonding pads and the lower bonding pads in a vertical direction (Z),
wherein each of the plurality of memory cell arrays comprises a plurality of sub-planes (41a, 41b) arranged in the first direction (Y), each of the plurality of sub-planes extending in the second direction (X), and the plurality of sub-planes being respectively coupled with a plurality of different bit line groups, and
wherein each of the plurality of page buffer circuits comprises a plurality of page buffers (42a, 42b) respectively coupled with the plurality of sub-planes (41a, 41b).

12. The nonvolatile memory device (40, 50) of claim 11, wherein each of the plurality of sub-planes comprises a plurality of memory blocks, and
wherein each of the plurality of memory blocks comprises:
a channel structure (CH) extending in the vertical direction; and
a plurality of word lines (WL) coupled with the channel structure.

13. The nonvolatile memory device (40, 50) of claim 11, wherein each of the plurality of sub-planes comprises a plurality of memory blocks, and
wherein each of the plurality of memory blocks comprises:
a plurality of memory stacks stacked in the vertical direction, each of the plurality of memory stacks extending in the vertical direction; and
a plurality of word lines coupled with the plurality of memory stacks.

14. The nonvolatile memory device (40, 50) of claim 11, wherein each of the plurality of memory cell arrays further comprises a first common source plate (51a) extending in the first direction and a second common source plate (51b) extending in the first direction, the first common source plate and the second common source plate being disposed apart from each other in the second direction,
wherein each of the plurality of sub-planes comprises first memory blocks coupled with the first common source plate and second memory blocks coupled with the second common source plate, and
wherein the peripheral circuit region comprises a row decoder disposed under a region between the first common source plate and the second common source plate.

15. The nonvolatile memory device (40, 50) of claim 14, wherein each of the plurality of memory cell arrays further comprises a first word line group commonly coupled with the first memory blocks and the second memory blocks.
